(19) Europäisches Patentamt / European Patent Office / Office européen des brevets

(11) **EP 3 531 432 B1**

(12) **FASCICULE DE BREVET EUROPEEN**

(45) Date de publication et mention
de la délivrance du brevet:
**14.10.2020   Bulletin 2020/42**

(51) Int Cl.:
*H01F 10/32* [(2006.01)]      *H01L 43/08* [(2006.01)]

(21) Numéro de dépôt: **19158829.2**

(22) Date de dépôt: **22.02.2019**

(54) **JONCTION TUNNEL MAGNETIQUE A ANISOTROPIE DE FORME PERPENDICULAIRE ET VARIATION EN TEMPERATURE MINIMISEE, POINT MEMOIRE ET ELEMENT LOGIQUE COMPRENANT LA JONCTION TUNNEL MAGNETIQUE, PROCEDE DE FABRICATION DE LA JONCTION TUNNEL MAGNETIQUE**

MAGNETISCHER TUNNELÜBERGANG MIT SENKRECHTER ANISOTROPIE UND MINIMIERTER TEMPERATURVARIATION, SPEICHERPUNKT UND LOGIKELEMENT, DIE DEN MAGNETISCHEN TUNNELÜBERGANG UMFASSEN, UND HERSTELLUNGSVERFAHREN DES MAGNETISCHEN TUNNELÜBERGANGS

MAGNETIC TUNNEL JUNCTION WITH PERPENDICULAR ANISOTROPY AND MINIMISED TEMPERATURE VARIATION, MEMORY POINT AND LOGIC ELEMENT COMPRISING THE MAGNETIC TUNNEL JUNCTION, METHOD FOR MANUFACTURING THE MAGNETIC TUNNEL JUNCTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **23.02.2018   FR 1851605**

(43) Date de publication de la demande:
**28.08.2019   Bulletin 2019/35**

(73) Titulaires:
 • **Commissariat à l'Energie Atomique et aux Energies Alternatives**
   **75015 Paris (FR)**
 • **Centre National de la Recherche Scientifique - CNRS**
   **75016 Paris (FR)**
 • **Institut Polytechnique de Grenoble**
   **38000 Grenoble (FR)**

(72) Inventeurs:
 • **PERRISSIN-FABERT, Nicolas**
   **38054 GRENOBLE (FR)**
 • **DIENY, Bernard**
   **38054 GRENOBLE (FR)**
 • **PREJBEANU, Lucian**
   **38054 GRENOBLE (FR)**
 • **SOUSA, Ricardo**
   **38054 GRENOBLE (FR)**

(74) Mandataire: **Lebkiri, Alexandre**
   **Cabinet Camus Lebkiri**
   **25, Rue de Maubeuge**
   **75009 Paris (FR)**

(56) Documents cités:
   **US-A1- 2012 299 134**

 • **K. WATANABE ET AL: "Shape anisotropy revisited in single-digit nanometer magnetic tunnel junctions", NATURE COMMUNICATIONS, vol. 9, no. 1, 14 février 2018 (2018-02-14), XP055543291, DOI: 10.1038/s41467-018-03003-7**

**Description**

**DOMAINE TECHNIQUE DE L'INVENTION**

La présente invention concerne un dispositif magnétique comprenant une couche d'aimantation variable présentant une anisotropie magnétique perpendiculaire au plan des couches principalement induite par la forme de la couche d'aimantation variable. Un premier objet de l'invention est une jonction tunnel magnétique. Un deuxième objet de l'invention est un point mémoire comprenant la jonction tunnel magnétique. La variation thermique des propriétés magnétiques et électriques sur la gamme de température d'opération est minimisée. Un troisième objet de l'invention est un élément logique non volatile comprenant la jonction tunnel magnétique. Ces dispositifs trouvent notamment une application dans le domaine de la spintronique en particulier pour la réalisation de mémoires magnétiques à accès aléatoire (« Magnetic Random Access Memory » en anglais, MRAM) fonctionnant sur une large gamme de température notamment pour l'automobile, les applications industrielles, le domaine spatial mais aussi pour l'électronique grand public, le calcul haute performance, l'internet des objets. Un quatrième objet de l'invention est un procédé de fabrication de la jonction tunnel magnétique selon l'invention.

**ETAT DE L'ART**

Afin de répondre aux récurrents besoins d'augmentation de la densité des mémoires pour l'électronique CMOS, la taille des dispositifs ne cesse de décroître. Cependant, les mémoires les plus couramment utilisées comme mémoires de travail (« Dynamic Random Access Memory », DRAM et « Static Random Access Memory », SRAM) sont volatiles c'est-à-dire qu'elles doivent continuellement être alimentées en tension pour conserver l'information. Elles ont de plus en plus de problèmes de consommation d'énergie, notamment en mode statique, en raison d'un courant de fuite accru lié à leur diminution en taille. Les mémoires FLASH utilisées pour le stockage de données ou de codes sont non volatiles, c'est-à-dire qu'elles conservent leurs données en l'absence d'alimentation, mais ont une endurance à l'écriture limitée à au plus 100 000 cycles et leur réalisation en version embarquée est complexe, nécessitant de 15 à 20 niveaux de masques.

Différentes technologies de mémoires non volatiles denses, endurantes à l'écriture et plus faciles à intégrer en technologie CMOS que les mémoires FLASH embarquées, sont en développement. Elles sont très intéressantes afin de diminuer la consommation d'énergie. Parmi les différentes technologies de mémoires non-volatiles (mémoire à changement de phase, mémoire à oxyde résistif, mémoire ferroélectrique etc), les mémoires magnétiques MRAM (« magnetic random access memory » en langue anglaise) combinent un ensemble unique d'avantages : outre leur non-volatilité, elles sont rapides à l'écriture (~20ns), rapides à la lecture (quelques ns), peuvent être réalisées de façon dense (s'approchant de la densité des DRAMs), et présentent une endurance à l'écriture très supérieure à celle des mémoires FLASH (>$10^{10}$ cycles pour les MRAMs à comparer à <$10^5$ cycles pour les FLASH). Elles sont donc particulièrement intéressantes pour être intégrées dans les circuits électroniques. Ce type de mémoire est basé sur des jonctions tunnel magnétiques, formées par deux couches ferromagnétiques séparées par un oxyde isolant, généralement de l'oxyde de magnésium MgO. La résistance du dispositif varie typiquement d'un facteur compris entre 3 et 4 entre un état de résistance minimum $R_{min}$ obtenu lorsque les aimantations des deux couches ferromagnétiques sont parallèles l'une à l'autre à une valeur $R_{max}$ lorsqu'elles sont en alignement antiparallèle, fournissant ainsi un « 0 » ou un « 1 » numérique. On définit la magnétorésistance tunnel (TMR) comme étant le rapport TMR=($R_{max}$-$R_{min}$)/$R_{min}$. Dans un circuit électronique, la non-volatilité permet de réduire la consommation d'énergie en éteignant les parties temporairement inactives du circuit et donc en éliminant le courant de fuite dans ces parties. De nouvelles stratégies de coupure et déclenchement de l'alimentation (power gating en anglais) sont ainsi rendues possibles. Le concept de calcul électronique dans un circuit normalement éteint avec mise en marche instantanée (« Normally-Off/Instant-On computing » en langue anglaise) a même été introduit pour décrire cette approche (« Challenges toward gigabit-scale spin-transfer torque random access memory and beyond for normally off, green information technology infrastructure », Takayuki Kawahara, J. Appl. Phys. 109, 07D325, 2011).

Différentes familles de mémoires magnétiques ont été développées au cours des 20 dernières années. Elles diffèrent essentiellement par la façon dont l'information est écrite dans les points mémoires. Ecrire dans une mémoire MRAM revient à orienter l'aimantation d'une des électrodes magnétiques de la jonction tunnel (électrode appelée couche de stockage) parallèlement ou antiparallèlement à l'aimantation de la deuxième électrode d'aimantation fixe appelée couche de référence. Dans la première famille de MRAMs, l'écriture était faite par impulsions de champs magnétiques. Des produits commerciaux de la société EVERSPIN™ appelés Toggle MRAM ont utilisé ce procédé d'écriture à partir de 2006. Cependant, la densité de ces mémoires est limitée à quelques Mbit car le courant nécessaire pour produire les impulsions de champs magnétiques (~10mA), ne permet pas de descendre à des nœuds technologiques inférieurs à 90nm.

La deuxième famille de MRAM qui retient aujourd'hui le plus d'attention est la famille des MRAMs écrites par transfert de spin (« spin transfer torque », STT en langue anglaise). Il s'agit des STT-MRAM. Le phénomène de transfert de spin a été prédit en 1996 par Slonczewski (Slonczewski, J. C., 1996, "Current driven excitations of magnetic multilayers," J. Magn. Magn. Mater.159, L1-L7) et Berger (Berger, L., 1996, "Emission of spin waves by a magnetic multilayer traversed by a current", Phys. Rev. B 54, 4828-4830) et la possibilité d'utiliser ce phénomène pour faire commuter l'aimantation de couches magnétiques a été démontrée expérimentalement pour la première fois en 2000 (Katine, J.A., F. J. Albert, R. A. Buhrman, E. B. Myers, and D. C. Ralph, 2000, "Current-driven magnetization reversai and spin-wave excitations in Co /Cu /Co pillars," Phys. Rev. Lett.84, 3149-3152).

L'utilisation du transfert de spin pour écrire dans une jonction tunnel magnétique fournit une meilleure configuration, en particulier lorsque la densité est importante, c'est-à-dire lorsque la mémoire est de petite taille (typiquement inférieure à 50 nm de diamètre).

Deux paramètres sont très importants pour décrire les performances d'une STT-MRAM. Le premier est le facteur de stabilité thermique $\Delta = E_b/K_B T$. Dans cette expression, $E_b$ représente la barrière d'énergie séparant les deux états stables de l'aimantation de la couche de stockage, c'est-à-dire la barrière d'énergie qu'il faut franchir pour faire commuter l'aimantation de la couche de stockage de parallèle à antiparallèle à celle de la couche de référence ou réciproquement de antiparallèle à parallèle suivant la valeur que l'on veut écrire dans le point mémoire (« 0 » ou « 1 »). Cette barrière d'énergie est liée à l'anisotropie magnétique de la couche de stockage. Ce paramètre est très important car il détermine la durée de rétention de la mémoire, c'est-à-dire combien de temps la mémoire arrive à conserver l'information que l'on a écrit avant que des fluctuations thermiques ne viennent effacer cette information. Il permet aussi d'estimer le taux d'erreur au repos (en standby) ou lors de la lecture en fonction du temps et de la capacité de la mémoire. Comme il est connu de l'homme de l'art, pour des mémoires de capacité de l'ordre de 1Gbit, des facteurs de stabilité thermique de l'ordre de 80 sont requis mais la valeur exacte du $\Delta$ requis dépend du taux d'erreur que l'on tolère (B.Dieny, L.Prejbeanu, chapter Magnetic Random Access Memory, in Introduction to Magnetic Random Access Memory, edited by B.Dieny, R.B.Goldfarb, K.J.Lee, IEEE Press, J.Wiley). Les premières STT-MRAMs qui ont été développées présentent une aimantation planaire, c'est-à-dire que les aimantations de la couche de stockage et de la couche de référence sont orientées au repos dans le plan des couches. L'anisotropie de la couche de stockage est alors le plus souvent obtenue en donnant à la jonction tunnel magnétique une forme allongée dans le plan, en particulier une forme elliptique caractérisée par un grand axe typiquement 2 à 3 fois plus grand que le petit axe de l'ellipse. A ce moment-là, l'aimantation a tendance à s'aligner avec le grand axe de l'ellipse qui constitue l'axe facile d'aimantation, le petit axe étant à contrario l'axe difficile d'aimantation. La hauteur de barrière d'énergie pour faire passer l'aimantation de la couche de stockage d'un sens au sens opposé par rotation cohérente est donnée par l'expression approchée suivante (Apalkov, D., B. Dieny and J. M. Slaughter, Magnetoresistive Random Access Memory, Proceedings of the IEEE 104 (2016) 1796-1830) :

$E_b = \mu_0 \pi^2 (M_s L)^2 w(AR - 1)$ où $\mu_0$ est la permittivité du vide, $M_s$ l'aimantation de la couche de stockage, L l'épaisseur de la couche de stockage, $w$ la largeur de l'ellipse (dimension du petit axe), $AR$ le rapport d'aspect de l'ellipse c'est-à-dire le rapport de la longueur du grand axe divisé par la longueur du petit axe. Dans ces MRAMs à aimantation planaire, le rapport d'aspect est en général limité à 3 au maximum car au-delà, le renversement de l'aimantation ne se produit plus par rotation cohérente de l'aimantation mais par nucléation et propagation de parois. La hauteur de barrière n'augmente alors quasiment plus avec le rapport d'aspect.

Plus récemment, comme il va être expliqué plus loin, l'intérêt pour les STT-MRAMs s'est concentré sur les jonctions tunnel magnétiques à aimantation orientée hors du plan. Ceci est dû à deux raisons principales. D'une part, on arrive à créer des anisotropies beaucoup plus fortes en anisotropie perpendiculaire qu'en anisotropie planaire, notamment en jouant sur des phénomènes d'anisotropie interfaciale. Ceci permet de diminuer la taille des points mémoires tout en gardant un facteur de stabilité thermique suffisant. D'autre part, pour un même facteur de stabilité thermique donné, c'est-à-dire pour une durée de rétention donnée, il est connu que le courant critique de commutation est beaucoup plus faible pour les jonctions à aimantation perpendiculaire que pour les jonctions à aimantation planaire. Ceci sera expliqué plus en détails plus loin.

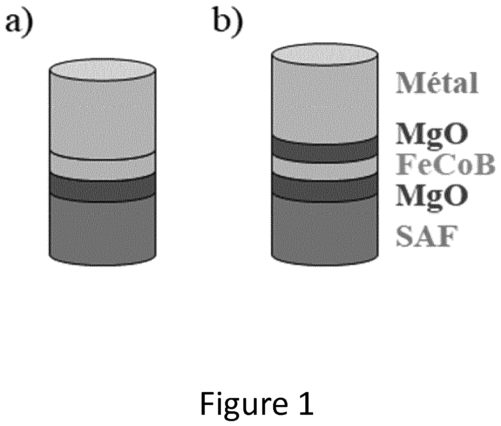

Les STT-MRAMs de l'état de l'art (Figure 1a et 1b) reposent sur un phénomène d'anisotropie perpendiculaire aux interfaces métal magnétique/oxyde (US8,247,093(B2), US 8,513,944(B2)). Ce phénomène a été observé avec différents oxydes (AlOx, MgO, TaOx, CrOx) et différents matériaux magnétiques à base de Co, Fe et leurs alliages mais est particulièrement intéressant aux interfaces CoFeB/MgO dans le contexte des STT-MRAMs (Ikeda, S., K. Miura, H. Yamamoto, K. Mizunuma, H. D. Gan, M. Endo, S. Kanai, J. Hayakawa, F. Matsukura, and H. Ohno, 2010, "A perpendicular-anisotropy CoFeB-MgO magnetic tunnel junction," Nature Mater. 9, 721-724). Cette anisotropie interfaciale est souvent notée $K_s$. C'est une énergie par unité de surface qui peut être de l'ordre de 1 à 2 mJ/m$^2$ à l'interface CoFeB/MgO. Il a été montré que cette anisotropie est plus élevée à l'interface Fe/MgO qu'elle ne l'est à l'interface Co/MgO (Yang, H. X., M. Chshiev, B. Dieny, J. H. Lee, A. Manchon, and K. H. Shin, 2011, "First principles investigation of the very large perpendicular magnetic anisotropy at Fe|MgO and Co|MgO interfaces," Phys. Rev. B 84, 054401). Cette anisotropie perpendiculaire interfaciale suffit dans les STT-MRAMs conventionnelles à tirer l'aimantation de la couche de stockage hors du plan en dépassant l'anisotropie de forme qui a plutôt tendance à rabattre l'aimantation dans le plan dans la mesure où l'épaisseur de la couche de stockage est très inférieure à son diamètre dans les STT-MRAMs de l'état de l'art.

Afin d'augmenter encore l'anisotropie interfaciale de la couche de stockage, il a aussi été proposé d'insérer la couche de stockage entre deux barrières d'oxyde (voir Figure 1b). Ceci permet de bénéficier des deux interfaces entre l'une et l'autre des barrières d'oxyde et la couche magnétique de stockage (US8,247,093(B2) ; US 8,513,944(B2) ; Sato, H., T. Yamamoto, M. Yamanouchi, S. Ikeda, S. Fukami, K. Kinoshita, F. Matsukura, N. Kasai, and H. Ohno, 2014, "Comprehensive study of CoFeB-MgO magnetic tunnel junction characteristics with single- and double-interface scaling down to 1X nm," in Proceedings of the International Electron Devices Meeting (IEDM), San Francisco, 33.2.1-33.2.4).

Dans les jonctions tunnel à aimantation perpendiculaire dans laquelle la couche de stockage a une forme généralement de cylindre aplati (c'est-à-dire ayant une épaisseur très inférieure au diamètre), la barrière d'énergie séparant les deux états d'aimantation de la couche de stockage (aimantation « vers le haut » ou aimantation « vers le bas) est donnée par :

$$E_b = A \left[ K_{s1} + K_{s2} - \frac{\mu_0}{2} (N_{xx} - N_{zz}) M_s^2 L + K_u L \right]$$

Dans cette expression, A représente la surface (aire) de la couche de stockage, $K_{s1}$ et $K_{s2}$ représentent les anisotropies interfaciales aux deux interfaces inférieure et supérieure de la couche de stockage, $N_{xx}$ et $N_{zz}$ sont les coefficients de champ démagnétisants suivant la direction x (direction choisie arbitrairement dans le plan compte tenu de la symétrie de révolution) et z (hors du plan), $\mu_0$, $M_s$ et L ont été définis précédemment, $K_u$ est une éventuelle anisotropie de volume par exemple d'origine magnétocrystalline ou magnétoélastique. En général, cette énergie est négligeable par rapport aux autres contributions à l'anisotropie pour les matériaux communément utilisés dans les STT-MRAMs. En ce qui concerne $N_{xx}$ et $N_{zz}$, tant que l'épaisseur de la couche est très inférieure à son diamètre, on a $N_{xx} \sim 0$ et $N_{zz} \sim 1$. Lorsque l'épaisseur n'est plus très inférieure au diamètre, une expression approchée de Nxx-Nzz est (M. Sato and Y. Ishii, J. Appl. Phys. 60, 983 (1989)) : $N_{xx} - N_{zz} = \frac{1}{2}\left(1 - \frac{3}{1+2f\,AR}\right),$ où $f$ = 1 dans le cas d'un parallélépipède rectangle à base carrée et $f = \frac{2}{\sqrt{\pi}}$ dans le cas d'un cylindre à base circulaire. Cette expression est pratique pour des calculs analytiques mais des valeurs plus précises de ces coefficients de champ démagnétisant peuvent être trouvées dans la publication Du-Xing Chen, James A. Brug, Member, IEEE, and Ronald B. Goldfarb, Demagnetizing Factors for Cylinders, IEEE Trans.Mag. 4, 3601 (1991) ou dans la publication suivante pour des cylindres de forme elliptique: M Beleggia, M De Graef, Y T Millev, D A Goode and G Rowlands, Demagnetization factors for elliptic cylinders, J. Phys. D: Appl. Phys. 38 (2005) 3333.

Rappelons que par convention, en magnétisme, lorsqu'une anisotropie est positive, elle tend à orienter l'aimantation hors du plan de la couche. Au contraire, lorsque l'anisotropie est négative, elle tend à orienter l'aimantation dans le plan.

Dans les STT-MRAM à anisotropie perpendiculaire de l'état de l'art, le terme d'anisotropie interfaciale $A(K_{s1}$

$$- A\left[\frac{\mu_0}{2}\left(N_{xx} - N_{zz}\right)M_s^2 L\right]$$

$+ K_{s2})$ est positif tandis que le terme lié à l'anisotropie de forme de la couche de stockage est négatif de sorte que les deux termes sont en compétition. Ceci est problématique dans les STT-MRAMs de l'état de l'art car empêche d'augmenter l'épaisseur $t$ de la couche de stockage. En effet, en augmentant cette épaisseur, on augmente le poids relatif de l'anisotropie de forme planaire par rapport à l'anisotropie interfaciale perpendiculaire ce qui réduit l'anisotropie totale effective. C'est pour cela que dans les STT-MRAMs perpendiculaires conventionnelles, l'épaisseur de la couche de stockage est limitée à des valeurs de l'ordre de 1.4nm pour les jonctions à simple barrière tunnel et à environ 2nm pour les jonctions à double barrière.

Un autre problème des mémoires MRAM de l'état de l'art à aimantation hors du plan est que la hauteur de barrière est proportionnelle à la surface de la jonction tunnel. Plus on avance vers des nœuds technologiques de plus en plus petits, plus cette surface A diminue. En conséquence $E_b$ diminue et il y a toujours un seuil de diamètre en dessous duquel le facteur de stabilité thermique devient trop petit pour assurer une rétention suffisante et donc un taux d'erreur suffisamment faible dans la conservation des données écrites dans la mémoire. Typiquement, avec les mémoires de l'état de l'art, le diamètre critique en dessous duquel la hauteur de barrière d'énergie devient trop faible à 85°C se situe autour de 25nm, à 150°C, elle se situe autour de 40nm.

Un deuxième paramètre très important pour caractériser un point mémoire STT-MRAM est son courant d'écriture $I_{c0}$. Il est connu de l'homme de l'art que le courant d'écriture dans une STT-MRAM dépend de la durée des impulsions de courant d'écriture. Dans le régime dit activé thermiquement observé pour des impulsions de durée typiquement

$$I_c = I_{c0}\left\{1 - \frac{k_B T}{E_b} Ln\left(\frac{\tau}{\tau_0}\right)\right\}$$

supérieure à 10ns, le courant d'écriture varie comme : où $\tau$ est la durée de l'impulsion et $\tau_0$ un temps d'essai caractéristique de l'ordre de 1ns. Le courant d'écriture varie donc linéairement en fonction du Logarithme de la durée des impulsions. $I_{c0}$ correspond à l'extrapolation de ce comportement linéaire pour une durée d'impulsion de 1ns.

$I_{c0}$ est un paramètre très important car il détermine la taille du transistor de sélection connecté à la jonction tunnel. Pour une résistance donnée du point mémoire, laquelle est en général ajustée pour être de l'ordre de grandeur de celle du transistor en mode passant, ce courant d'écriture va déterminer la tension d'écriture. Le produit résistance*surface (RA) de la jonction tunnel est en général ajusté en jouant sur l'épaisseur de la barrière tunnel pour que cette tension se situe autour de 0.3 à 0.5V, suffisamment basse par rapport à la tension de claquage diélectrique de la barrière tunnel (~1.2 à 1.6V) pour assurer une endurance à l'écriture quasi illimitée du point mémoire. Par ailleurs le courant d'écriture influe sur la consommation électrique que l'on cherche la plupart du temps à minimiser surtout pour les applications nomades ou les dispositifs de l'internet des objets.

Du point de vue théorique, le courant d'écriture est donné par les expressions suivantes (Sun, J. Z, 2000, "Spin-current interaction with a monodomain magnetic body: A model study," Phys. Rev. B 62, 570-578.) :

- Pour les STT-MRAMs à aimantation planaire :

$$I_c^0 = A j_c^0 = \frac{A}{\eta}\frac{2\alpha e\mu_0}{\bar{h}}(M_s L)\left(\frac{H_\perp^{eff}}{2} + H_K\right)$$

Dans cette expression, $A$ est l'aire de la jonction, $j_c^0$ est la densité de courant critique pour écrire, $\eta$ est l'efficacité du couple de transfert de spin liée à la polarisation en spin du courant injecté dans la couche de stockage au moment de l'écriture (typiquement ~80% pour des barrières de MgO de l'état de l'art), $\bar{h}$ est la constante de Planck réduite, e la valeur absolue de la charge de l'électron, $\alpha$ est l'amortissement de Gilbert du matériau constitutif de la couche de stockage, $M_s$ son aimantation, $L$ l'épaisseur de la couche stockage, e la charge de l'électron, $\mu_0$ la permittivité du vide.

Par ailleurs, $H_\perp^{eff}$ représente le champ démagnétisant effectif ressenti par l'aimantation de la couche de stockage si

$$\mu_0 H_\perp^{eff} = \mu_0 M_s - 2\left(\frac{K_s}{L} + K_u\right).$$

elle pointe hors du plan, ce champ étant donné par Enfin, $H_K$ est le champ d'anisotropie planaire qui définit la rétention de la mémoire, $H_K$ étant donné par $\mu_0 M_s H_K = E_b = \mu_0 \pi^2 (M_s L)^2 w (AR - 1)$. Comme il est connu de l'homme de l'art, dans ce cas des jonctions tunnel magnétiques à aimantation planaire, la barrière d'énergie à franchir pour faire commuter l'aimantation par STT (proportionnelle à $\left(\frac{H_\perp^{eff}}{2} + H_K\right)$) est bien plus élevée que celle qui détermine la rétention de la mémoire (proportionnelle à $(H_K)$). Ceci est défavorable car signifie que pour une rétention de la mémoire donnée, il faut fournir plus de courant pour vaincre la barrière plus élevée associée à la commutation que nécessaire de par la rétention de la mémoire. Ce coût additionnel en courant lors de la commutation provient du fait que dans sa dynamique de commutation par STT, l'aimantation est forcée à sortir du plan de la couche, ce qui coûte beaucoup d'énergie additionnelle.

- Pour les STT-MRAMs à aimantation perpendiculaire : $I_c^0 = A j_c^0 = \frac{A}{\eta}\frac{2\alpha e\mu_0}{\bar{h}}(M_s L)\left(H_K^{eff}\right)$ où les notations sont les mêmes que ci-dessus et $H_K^{eff}$ représente le champ d'anisotropie perpendiculaire effectif ressenti par l'aimantation de la couche de stockage, lequel est donné par :

$$\mu_0 H_K^{eff} = \mu_0 (N_{xx} - N_{zz}) M_s + \frac{2}{M_s}\left(\frac{K_{s1} + K_{s2}}{L} + K_u\right).$$

Dans les STT-MRAMs de l'état de l'art, ce champ d'anisotropie perpendiculaire effectif est essentiellement dû à l'anisotropie interfaciale aux interfaces entre la couche de stockage et les deux couches adjacentes qui sont le plus souvent deux couches d'oxydes en MgO. Ce champ d'anisotropie est réduit par le champ démagnétisant exprimé par le terme $\mu_0(N_{xx} - N_{zz})M_s$ opposé au terme de champ d'anisotropie lié aux interfaces. Le terme en $K_u$ correspond à l'existence éventuelle d'une anisotropie de volume d'origine magnétocrystalline ou magnétoélastique, en général négligeable.

En combinant les deux expressions ci-dessus avec celle donnée précédemment pour la hauteur de barrière en anisotropie perpendiculaire, on déduit :

$$I_c^0 = \left(\frac{4e}{\hbar}\right)\frac{\alpha E_b}{\eta}.$$

Cette relation, valable dès que l'aimantation se comporte de façon macrospin c'est-à-dire comme un bloc d'aimantation uniforme, montre que le courant d'écriture est directement proportionnel à la barrière $E_b$ qui détermine la rétention de la mémoire. Ceci est beaucoup plus favorable que pour les jonctions tunnel planaires pour lesquelles un coût en courant d'écriture additionnel était nécessaire pour réaliser la commutation de l'aimantation de la couche de stockage. Ceci explique l'intérêt supérieur des jonctions tunnel à aimantation hors du plan pour les STT-MRAMs comparativement aux jonctions à aimantation planaire. Toutefois dans l'état de l'art, il est connu que l'amortissement de Gilbert $\alpha$ augmente pour les couches très minces à cause de phénomènes de pompage de spin (spin-pumping) (Ikeda, S., K. Miura, H. Yamamoto, K. Mizunuma, H. D. Gan, M. Endo, S. Kanai, J. Hayakawa, F. Matsukura, and H. Ohno, 2010, "A perpendicular-anisotropy CoFeB-MgO magnetic tunnel junction," Nature Mater. 9, 721-724). Ceci augmente d'autant le courant d'écriture qui lui est proportionnel.

Par ailleurs, pour beaucoup d'applications de microcontrôleurs, on souhaite que le code faisant fonctionner le microcontrôleur soit stocké dans une mémoire non-volatile du microcontrôleur à la fabrication du microcontrôleur et que cette information stockée dans la mémoire reste intègre lors de la soudure de la puce sur son support (solder reflow compliance). Cette étape de soudure implique typiquement une élévation de température à 260°C pendant 1 minute. Dans les mémoires STT-MRAMs de l'état de l'art, satisfaire cette condition est difficile du fait de la forte variation thermique de l'anisotropie interfaciale aux interfaces CoFeB/MgO. Ceci impose de renforcer l'anisotropie de sorte qu'elle reste suffisamment forte à 260°C pour permettre une rétention de 1 minute à cette température mais du coup l'anisotropie est encore beaucoup plus forte à 25°C voire à -40°C ce qui conduit à un courant d'écriture supérieur et donc une consommation à l'écriture plus importante et une tension d'écriture plus importante donc une endurance à l'écriture réduite.

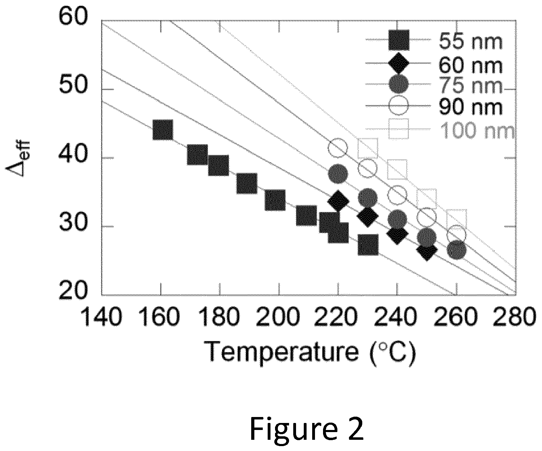

La Figure 2 illustre ceci. Cette figure montre l'évolution en fonction de la température du facteur de stabilité thermique de jonctions tunnel de l'état de l'art jusqu'à 260°C. Pour avoir un taux d'erreur par bit inférieur à $10^{-4}$ pendant

60 secondes à 260°C il faut que le facteur de stabilité thermique $\Delta$ satisfasse la relation $\frac{t}{\tau_0}\exp(-\Delta) < 10^{-4}$ où t=60s, $\tau_0=10^{-9}$s. Ceci impose $\Delta>34$. La Figure 2 montre que ceci n'est satisfait que pour les plus grandes jonctions de diamètre supérieur à 100nm. Par ailleurs, si on extrapole la variation thermique du facteur de stabilité jusqu'à la température ambiante de 25°C, on trouve que celui-ci atteint 115 ce qui est beaucoup plus que requis par bit pour une rétention de 10ans. Ceci implique que le courant d'écriture et la tension d'écriture devront être surdimensionnés à 25°C au prix d'une consommation électrique accrue et d'une endurance à l'écriture réduite pour satisfaire le critère de rétention de 60s à 260°C.

K. Watanabe ET AL. Nature Communications, vol. 9, no. 1, 14 février 2018, présente une jonction tunnel magnétique de type nanopilier dans laquelle la couche de stockage FeB est d'une épaisseur accrue vis-à-vis du diamètre du nanopilier afin augmenter l'anisotropie de forme par rapport à l'anisotropie interfaciale.

Pour résumer, les jonctions tunnel magnétiques de l'état de l'art et les points mémoire qui les utilisent ne permettent pas de :

- Réduire les variations d'anisotropie magnétique sur la gamme de température de -40°C à +260°C permettant de couvrir la gamme de températures d'opération pour les applications automobiles, industrielles, militaires et aussi de conserver la rétention de la mémoire pendant l'étape de soudure de la puce ;
- Arriver à conserver un facteur de stabilité thermique suffisamment grand dans des jonctions tunnels dont le diamètre correspond aux nœuds technologiques les plus avancés (de 40nm jusqu'à 4nm) ;
- Minimiser le courant d'écriture.

## DESCRIPTION GENERALE DE L'INVENTION

Pour résoudre au moins partiellement ces problèmes techniques, un objet de la présente invention est une jonction tunnel magnétique à aimantation hors du plan, selon la revendication 1, comprenant :

- une couche de stockage ayant une aimantation commutable entre deux états d'aimantation perpendiculaire au plan de la couche ;
- une couche de référence ayant une aimantation fixe et perpendiculaire au plan de la couche ;
- une couche barrière tunnel séparant la couche de stockage et la couche de référence ;
- les deux états d'aimantation de la couche de stockage étant séparés par une barrière d'énergie comprenant une contribution due à l'anisotropie de forme de la couche de stockage et une contribution d'origine interfaciale pour chaque interface de la couche de stockage, ladite jonction tunnel magnétique étant caractérisée en ce que :

  ◦ la couche de stockage présente une épaisseur comprise entre 0.8 et 8 fois une dimension caractéristique d'une section planaire de la jonction tunnel ;
  ◦ et en ce que la contribution à la barrière d'énergie due à l'anisotropie de forme de la couche de stockage est au moins deux fois supérieure aux contributions à la barrière d'énergie d'origine interfaciale;

la couche de stockage comporte une couche interfaciale faite d'un alliage riche en cobalt au contact de la barrière tunnel.

Selon un mode de réalisation la contribution à la barrière d'énergie due à l'anisotropie de forme de la couche de stockage est au moins quatre fois supérieure aux contributions à la barrière d'énergie d'origine interfaciale.

On entend par barrière d'énergie séparant les deux états d'aimantation de la couche de stockage la différence d'énergie entre le minimum d'énergie correspondant à l'état initial stable de l'aimantation de la couche de stockage et le maximum d'énergie rencontré au cours du retournement de l'aimantation vers son état final stable.

On entend par section planaire de la jonction tunnel une section de la jonction tunnel selon le plan des couches formant la jonction tunnel.

On entend par dimension caractéristique d'une section planaire une dimension de ladite section planaire. Par exemple, en cas de jonction tunnel ayant une section circulaire, la dimension caractéristique d'une section planaire de la jonction tunnel peut être choisie comme étant le diamètre du cercle. En cas de section elliptique, la dimension caractéristique peut être choisie comme étant le petit axe ou le grand axe de l'ellipse.

Par exemple, la contribution à la barrière d'énergie due à l'anisotropie de forme de la couche de stockage peut être donnée par la formule suivante dans le cas d'une couche de stockage de forme cylindrique :

$$-\frac{\mu_0}{4}\left(1-\frac{3}{1+4AR/\sqrt{\pi}}\right)M_s^2(T)AL$$

Par exemple, la contribution à la barrière d'énergie d'origine interfaciale peut être donnée par la formule suivante :

$$A\left(K_{s1}+K_{s2}\right)$$

L'explication des symboles utilisés dans ces formules a été donnée plus haut.

On peut considérer que ces contributions à la barrière d'énergie sont calculées à une température $T_m$ étant la température moyenne d'utilisation de la jonction magnétique tunnel.

La jonction magnétique tunnel étant utilisée à des températures comprises entre $T_1$ et $T_2$, la température $T_m$ est par exemple définie comme $T_m = (T_1 + T_2)/2$. Avantageusement, la jonction tunnel magnétique selon l'invention permet d'augmenter l'épaisseur de la couche de stockage. Ceci permet de réduire l'influence de la température d'opération sur la densité de fluctuations thermiques dans la couche de stockage et donc par la même, sur la rétention de la mémoire et la valeur du courant d'écriture.

Avantageusement, l'augmentation de l'épaisseur de la couche de stockage permet l'utilisation de matériaux et d'épaisseurs ayant un plus faible amortissement de Gilbert et donc la minimisation du courant d'écriture.

Le principe de l'invention peut être expliqué de la façon suivante :

Dans l'état de l'art, les STT-MRAMs ont toujours utilisé des couches de stockage très minces dont l'épaisseur est bien inférieure au diamètre. Ceci était motivé en particulier par le fait que le transfert de spin étant un phénomène interfacial (se produisant typiquement sur le premier nanomètre à partir de l'interface par où le courant polarisé en spin est injecté), il est préférable d'utiliser des couches très minces pour ne pas diluer l'efficacité du couple de transfert de spin. Pour de telles couches très minces, l'anisotropie de forme favorise une orientation dans le plan de l'aimantation de la couche de stockage et s'oppose donc à l'anisotropie interfaciale qui, elle, favorise une orientation perpendiculaire de cette aimantation. Ceci conduit à une anisotropie effective d'amplitude relativement moyenne résultant de la compétition de ces deux termes d'anisotropie. Par ailleurs, cette anisotropie dépend fortement de la température car les fluctuations thermiques d'aimantation se développent plus rapidement quand la température augmente dans une couche très mince (épaisseur de la couche de stockage dans les STT-MRAMs de l'état de l'art ~1.4nm à 2nm) que dans une couche épaisse du même matériau.

La présente invention propose de réduire cette dépendance en température de l'anisotropie en changeant complétement de paradigme en utilisant une couche de stockage beaucoup plus épaisse c'est-à-dire dont l'épaisseur est d'au moins 80% d'une dimension planaire caractéristique de la couche de stockage (longueur du petit axe pour un point mémoire de forme elliptique ou diamètre pour un point mémoire de forme cylindrique) de sorte que l'anisotropie de forme favorise aussi une orientation hors du plan de l'aimantation et devient même la principale source d'anisotropie perpendiculaire de la couche de stockage. L'idée de base est que l'anisotropie interfaciale aux interfaces CoFeB/MgO utilisée dans les STT-MRAMs de l'état de l'art dépend beaucoup plus fortement de la température que l'anisotropie de forme d'une couche épaisse qui varie proportionnellement à $M_s^2$, sachant que pour une couche épaisse la variation thermique de $M_s(T)$ est proche de celle du matériau massif de même composition. Dans le présent brevet, l'anisotropie de forme et l'anisotropie d'interface ont le même signe et donc s'ajoutent de sorte que toutes les deux favorisent une orientation perpendiculaire au plan des couches de l'aimantation de la couche de stockage. Toutefois, comme l'anisotropie d'interface varie plus rapidement en température que l'anisotropie de forme, on cherchera à augmenter le rôle relatif de l'anisotropie de forme par rapport à l'anisotropie d'interface pour minimiser la dépendance de l'anisotropie totale à la température d'opération.

Pour bien comprendre l'idée, nous utilisons ici le cas le plus courant d'une jonction tunnel dont la couche de stockage a une forme quasi cylindrique. Dans ce cas et en supposant que la couche de stockage est constituée d'un seul matériau d'aimantation $M_s$, la barrière d'énergie séparant les deux états d'aimantation « vers le haut » et « vers le bas » peut s'exprimer par :

$$E_b(T) = A\left[K_{s1}(T) + K_{s2}(T) - \frac{\mu_0}{4}\left(1 - \frac{3}{1 + 4AR/\sqrt{\pi}}\right)M_s^2(T)L + K_u(T)L\right]$$

$$AR = \frac{\sqrt{\pi}}{2} \approx 0.89$$

Cette expression montre que dès que le rapport de forme de la couche de stockage dépasse

alors le terme d'anisotropie de forme $-\frac{\mu_0}{4}\left(1 - \frac{3}{1 + 4AR/\sqrt{\pi}}\right)M_s^2 L$ change de signe pour passer de négatif à positif. En d'autres termes, pour un rapport d'aspect épaisseur/diamètre plus grand que 0.89, l'anisotropie de forme s'ajoute à l'anisotropie perpendiculaire d'interface présente à l'interface barrière tunnel/couche de stockage. Dans cette expression, l'anisotropie $K_u$ d'origine magnétocrystalline ou magnétoélastique est en général négligeable comparativement aux autres termes d'anisotropie, avec les matériaux couramment utilisés comme les alliages à base de Co, de Fe et de Ni déposés par pulvérisation cathodique. La hauteur de barrière $\Delta E(T)$ dépend donc de la température à travers la dépendance en température de l'anisotropie interfaciale $A(K_{s1}(T) + K_{s2}(T))$ et celle de l'anisotropie de forme

$$-\frac{\mu_0}{4}\left(1 - \frac{3}{1 + 4AR/\sqrt{\pi}}\right)M_s^2(T)At .$$

Nous comparons ci-dessous les variations thermiques de ces deux termes d'anisotropie.

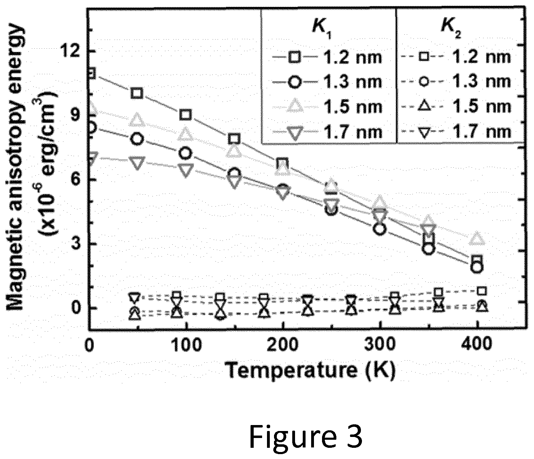

La figure 3 montre des variations typiques d'anisotropie interfaciales telles que celles des couches de stockage de jonctions tunnel magnétiques de l'état de l'art. La figure montre en fait les contributions à l'anisotropie interfaciale de premier ordre (uniaxial en $\sin^2 \theta$, $\theta$ angle entre l'aimantation de la couche de stockage et la normale au plan des couches) et de second ordre (en $\sin^4 \theta$) de multicouches W/CoFeB/MgO avec différentes épaisseurs de CoFeB (Kyoung-Min Lee, Jun Woo Choi, Junghyun Sok, and Byoung-Chul Min, Temperature dependence of the interfacial magnetic anisotropy in W/CoFeB/MgO, AIP Advances 7, 065107 (2017)). La contribution de second ordre est beaucoup plus faible que celle de premier ordre est peut être négligée. Cette figure montre que l'anisotropie interfaciale provenant de l'interface CoFeB/MgO décroit d'environ un facteur 2 entre 300K (27°C) et 400K (127°C) et s'extrapole à zéro bien avant d'atteindre les 260°C. Ceci indique de fortes variations thermiques de cette anisotropie interfaciale comme discuté précédemment en relation avec la Figure 2.

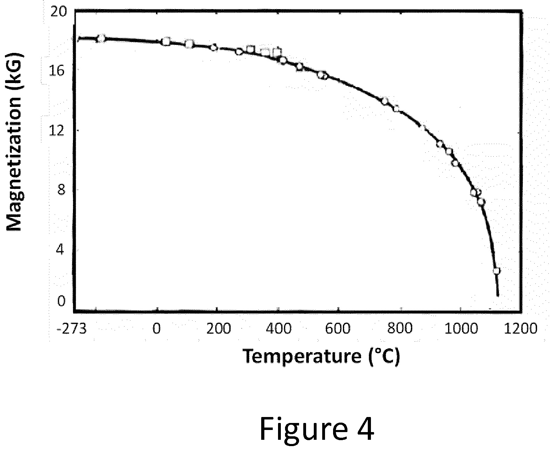

La Figure 4 présente la variation thermique de l'aimantation d'un matériau massif comme le cobalt dont la température de Curie est élevée : 1394K (courbe extraite de Ferromagnetism, Bozorth, Van Nostrand company, Inc). Cette courbe montre que la variation thermique de l'aimantation du cobalt est inférieure à 4% entre 0°C et 260°C. Si la couche de stockage de la STT-MRAM est une couche épaisse à base de cobalt, le terme d'anisotropie de forme

$$-\frac{\mu_0}{4}\left(1-\frac{3}{1+4AR/\sqrt{\pi}}\right)M_s^2(T)AL$$ proportionnel à $M_s^2(T)$ ne variera que de 8% ce qui est bien moins que le facteur d'au moins 2 de la variation thermique de l'anisotropie interfaciale.

Pour réduire la variation thermique de l'anisotropie effective, on aura donc tout intérêt à réduire le poids relatif de l'anisotropie interfaciale par rapport à l'anisotropie de volume dans l'anisotropie totale de la couche de stockage. Ceci va à l'opposé des jonctions tunnel perpendiculaires de l'état de l'art dans lesquelles l'anisotropie perpendiculaire provient entièrement de l'anisotropie interfaciale à l'interface MgO/CoFeB. Réduire l'anisotropie interfaciale dans la présente invention pourra être réalisé en particulier en utilisant un alliage riche en cobalt au niveau de l'interface avec la barrière de MgO dans la mesure où il est connu que l'anisotropie perpendiculaire aux interfaces MgO/cobalt est plus faible que celle aux interfaces MgO/Fe (Yang, H. X., M. Chshiev, B. Dieny, J. H. Lee, A. Manchon, and K. H. Shin, 2011, "First principles investigation of the very large perpendicular magnetic anisotropy at Fe|MgO and Co|MgO interfaces," Phys. Rev. B 84, 054401). Par ailleurs le cobalt ayant une température de Curie plus élevée que le fer, cette anisotropie interfaciale restante variera plus faiblement en température que l'anisotropie interfaciale à l'interface MgO/Fe.

En particulier, on peut écrire la barrière d'énergie de façon simplifiée en négligeant l'anisotropie de volume d'origine magnétocrystalline ou magnétoélastique :

$$E_b(T) = A[K_s(T) + K_v(T)L]$$

où $K_s(T)$ regroupe les termes d'anisotropie interfaciale et $K_v(T)$ l'anisotropie volumique de forme proportionnelle à Ms2. Comme le montrent les figures 3 et 4, l'anisotropie d'interface décroit en général beaucoup plus vite en température que l'anisotropie de volume. Afin de minimiser la variation thermique de la hauteur de barrière et donc du courant d'écriture sur la gamme de températures d'opération du dispositif, on cherchera donc à renforcer l'importance relative de l'anisotropie de forme volumique par rapport à l'anisotropie d'interface.

Typiquement, d'après la Figure 3, l'anisotropie d'interface $K_s$ aux interfaces MgO/FeCoB varie d'environ 50% pour une variation thermique de 100°C autour de la température ambiante. Pour des matériaux comme le Co la variation de Ms2 et donc de $K_v$ n'est que de 6%. Si on veut avoir une variation de la hauteur de barrière $E_b$ et donc du courant d'écriture inférieure à 20%, il faudra que la proportion X de l'anisotropie de forme par rapport à l'anisotropie d'interface soit choisie de sorte que 20%>(50%+X*6%)/(1+X) soit X>2.14 que l'on peut approximer à 2. Si on veut que cette variation soit plus faible que 15%, alors il faut augmenter la proportion d'anisotropie de volume de sorte que 15%>(50%+X*6%)/(1+X) soit X>3.89 que l'on peut approximer par 4.

En résumé, si l'anisotropie de forme est deux fois plus grande que l'anisotropie d'interface, en utilisant un matériau pour la couche de stockage à haute température de Curie comme un alliage riche en cobalt, la variation de la hauteur de barrière et donc du courant d'écriture sera de l'ordre de 20% pour une variation de température de 100°C autour de la température ambiante.

Si l'anisotropie de forme est quatre fois plus grande que l'anisotropie d'interface, la variation de la hauteur de barrière sera de 15%. Dans la limite où l'anisotropie de forme serait beaucoup plus grande que l'anisotropie d'interface, cette variation pourrait être réduite à des valeurs de l'ordre de 6% si la couche de stockage a une très haute température de Curie comme le cobalt.

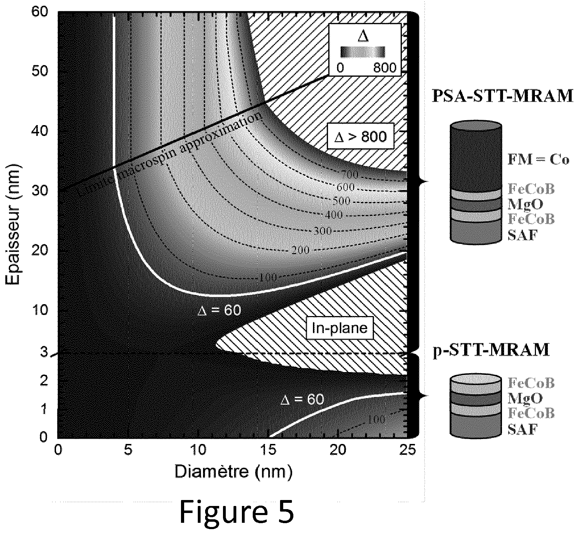

La possibilité d'utiliser l'anisotropie de forme perpendiculaire pour orienter l'aimantation de la couche de stockage hors du plan et ainsi obtenir des valeurs importantes du facteur de stabilité thermique (∆>60) aux petites tailles (sub-20nm) est illustrée sur la Figure 5.

Celle-ci représente le facteur de stabilité thermique ∆ en code couleur en fonction du diamètre de la couche de stockage et de son épaisseur. Les paramètres choisis pour établir ce diagramme correspondent à une couche de stockage en cobalt. Les STT-MRAM de l'état de l'art ou p-STT-MRAM se trouvent dans le coin en bas à droite de ce diagramme. Comme discuté précédemment, dans cette situation de l'état de l'art, l'anisotropie effective et donc le facteur de stabilité thermique diminue si l'épaisseur de la couche augmente. Pour une épaisseur de la couche de stockage minimale de l'ordre de 1.5nm pour avoir une magnétorésistance tunnel suffisante, le diagramme montre qu'on ne peut pas descendre en dessous d'un diamètre de l'ordre de 20nm en gardant un facteur de stabilité thermique supérieur à 60.

Par contre, si on passe dans le régime exploité par la présente invention où l'épaisseur de la couche de stockage devient beaucoup plus importante (partie supérieure du diagramme, PSA-STT-MRAM) alors de très fortes valeurs du facteur de stabilité thermique (Δ>60) peuvent être obtenues et ceci jusqu'à des diamètres de l'ordre de 4nm.

Le diagramme fait apparaitre la ligne de limite de l'approximation macrospin. En dessous de cette limite, on peut considérer que l'aimantation de la couche de stockage se retourne de façon cohérente alors qu'au-dessus de cette ligne, le retournement de l'aimantation va plutôt se faire avec une déformation importante de l'aimantation pouvant comprendre la nucléation d'un domaine inverse et la propagation de la paroi magnétique séparant ce domaine inverse du reste de la couche.

Tant qu'on reste dans la région où l'approximation macrospin est valable, la relation

$$I_c^0 = \left(\frac{4e}{\hbar}\right)\frac{\alpha E_b}{\eta} = \left(\frac{4e}{\hbar}\right)\frac{\alpha k_B T \Delta}{\eta}$$

reste valable.

Ceci montre un résultat contrintuitif : Bien qu'on augmente considérablement l'épaisseur de la couche de stockage par rapport aux STT-MRAM de l'état de l'art, le courant d'écriture ne sera pas augmenté tant qu'on reste dans la même gamme de valeurs du facteur de stabilité thermique Δ requis par les applications, c'est-à-dire typiquement Δ entre 60 et 100 suivant la capacité de la mémoire et le taux d'erreur tolérable.

Au contraire, le fait d'augmenter l'épaisseur de la couche de stockage a plusieurs avantages :

- Une couche épaisse possède des propriétés magnétiques beaucoup plus proches du matériau massif (bulk) qu'une couche très fine comme le sont les couches de stockage habituellement utilisées dans les p-STT-MRAMs de l'état de l'art (couches de 1.5nm à 2nm d'épaisseur). En particulier, les fluctuations thermiques se développent moins vite en fonction de la température que dans une couche très mince. En effet, il est connu que du fait du nombre réduit d'atomes voisins en surface d'une couche magnétique, la température d'ordre magnétique tend à s'abaisser dans les couches ferromagnétiques de quelques plans atomiques d'épaisseur. Ceci veut dire que les fluctuations thermiques se développent de façon plus importante dans les couches très minces que dans les matériaux massifs de même composition. Dans le contexte des p-STT-MRAMs de l'état de l'art, ceci se traduit par une décroissance rapide de la magnétorésistance tunnel et de l'anisotropie magnétique en fonction de la température, ce qui est gênant si le dispositif doit fonctionner sur une large gamme de température (-40°C à +150°C pour l'automobile) ou doit arriver à garder la mémoire pendant une opération de soudure pouvant entrainer une élévation de température à 260°C pendant une minute (solder reflow compliance). Ainsi, comme le courant d'écriture est proportionnel à $E_b$, la forte variation d'anisotropie sur la gamme d'opération des p-STT-MRAMs conventionnelles conduit à une faible rétention à la limite supérieure de la gamme d'opération et à un fort courant d'écriture à la limite inférieure de la gamme d'opération. Grace à l'utilisation de couches magnétiques épaisses comme proposé dans la présente invention, on diminue fortement cette variation thermique qui ressemble beaucoup plus à celle du matériau massif. Ainsi à titre d'exemple, le cobalt massif ne voit son aimantation varier que de quelques % (~3%) entre -40°C et 150°C alors qu'en couches d'épaisseur 1.5nm, cette variation peut être de 30 à 40%.
- Un second avantage concerne l'amortissement de Gilbert qui intervient directement dans le courant d'écriture. Tant qu'on reste dans le régime macrospin, l'amortissement de Gilbert α qui figure dans l'expression du courant d'écriture est l'amortissement de Gilbert moyen sur tout le volume de la couche de stockage. Des optimisations sont alors possibles pour obtenir une forte magnétorésistance tunnel et un amortissement moyen faible comme expliqué ci-dessous.

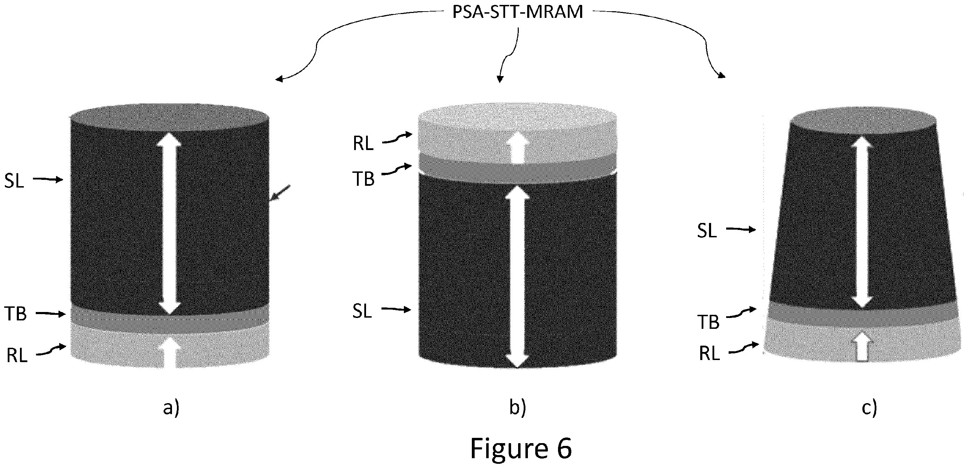

Ainsi l'objet de la présente invention est une jonction tunnel à aimantation perpendiculaire au plan des couches (Figure 6) dans laquelle l'anisotropie perpendiculaire trouve principalement sa source en une anisotropie de forme verticale obtenue en donnant à la couche de stockage un rapport de forme épaisseur/dimension caractéristique planaire compris entre 0.8 et 8 et caractérisé en ce que l'anisotropie de forme est positive et supérieure à l'anisotropie interfaciale.

Par ailleurs, l'idée principale de la présente invention qui est d'augmenter le poids relatif de l'anisotropie de volume (qui dépend faiblement de la température) par rapport à l'anisotropie d'interface (qui dépend fortement de la température) peut être combinée avec l'optimisation du choix de l'aimantation du matériau principal constitutif de la jonction tunnel et de l'épaisseur de cette dernière pour minimiser les effets de dispersion des propriétés de point mémoire à point mémoire lors de la fabrication d'une puce mémoire, comme il est expliqué plus loin.

Selon l'invention, la couche de stockage comporte une couche interfaciale faite d'un alliage riche en cobalt au contact de la barrière tunnel.

Le dispositif selon l'invention peut également présenter une ou plusieurs des caractéristiques ci-dessous, considérées individuellement ou selon toutes les combinaisons techniquement possibles :

- la couche de stockage comporte une couche volumique présentant une température de Curie supérieure à 400°C et de préférence supérieure à 600°C et de préférence supérieure à 800°C ;

- la jonction tunnel comporte une seule couche barrière tunnel ;

- la couche de stockage comprend un ou plusieurs matériaux magnétiques présentant une température de Curie supérieure à 400°C et de préférence supérieure à 600°C et de préférence supérieure à 800°C ;

- la couche de stockage comprend un alliage comprenant du cobalt et/ou du fer et un élément amorphisant tel que le bore, ledit alliage étant en contact avec la barrière tunnel ;

- la couche de stockage contient une ou plusieurs couches de matériaux tels que du Ta, W, Mo, Hf, aptes à absorber l'élément amorphisant présent dans la couche de stockage et à assurer des transitions structurales entre les différents matériaux magnétiques compris dans la couche de stockage ;

- la section planaire de la jonction tunnel magnétique est circulaire ou quasi circulaire et la dimension caractéristique est le diamètre de la section ;

- le diamètre de la jonction tunnel magnétique est inférieur à 50nm ;

- la couche barrière tunnel est réalisée en MgO, AlOx, AlN, $SrTiO_3$, HfOx ou tout autre oxyde ou nitride isolant ;

- la couche de stockage comprend :

  ◦ une couche en alliage de cobalt, fer et élément amorphisant d'épaisseur entre 1 et 4nm en contact avec la barrière tunnel ;
  ◦ une couche d'un matériau apte à absorber le bore, tel que Ta, Mo, W, Hf au moment des recuits post-dépôt, d'épaisseur 0.2 à 0.4nm ;
  ◦ une couche magnétique à faible amortissement de Gilbert ;

- la jonction tunnel magnétique selon l'invention possède les propriétés suivantes :

  ◦ la jonction tunnel magnétique possède un facteur de stabilité dépendant de la barrière d'énergie et de la température d'utilisation de la jonction tunnel magnétique ;
  ◦ la composition et l'épaisseur de la couche de stockage sont choisies de sorte que la valeur absolue de la dérivée du facteur de stabilité thermique par rapport à une dimension caractéristique d'une section planaire de la jonction tunnel soit inférieure à 10 $nm^{-1}$, la dérivée du facteur de stabilité étant calculée à une température $T_m$, la température $T_m$ étant la température moyenne d'utilisation de la jonction tunnel magnétique ;

- la couche de stockage est constituée d'un matériau magnétique homogène ;

- la couche de stockage comprend un ensemble de couches magnétiques et non magnétiques ;

- la couche de stockage comprend au moins une couche magnétique contenant un élément amorphisant tel que le bore et une ou plusieurs couches aptes à absorber l'élément amorphisant lors de recuit post-dépôt ;

- la couche de stockage comprend au moins deux matériaux magnétiques, dont un premier matériau proche de la barrière tunnel est apte à fournir une forte magnétorésistance tunnel et un deuxième matériau présente un faible amortissement de Gilbert ;

- la couche de stockage est insérée entre deux barrières tunnel.

Un autre objet de l'invention défini à la revendication 12, est une cellule de STT-MRAM comprenant une jonction tunnel selon l'invention ou point mémoire de type STT-MRAM comprenant une jonction tunnel magnétique selon l'invention. Un autre objet de l'invention défini à la revendication 13, est une cellule de SOT-MRAM comprenant une jonction tunnel selon l'invention ou point mémoire de type SOT-MRAM comprenant une jonction tunnel magnétique selon l'invention. Un autre objet de l'invention est une cellule de MRAM à écriture contrôlée en tension comprenant une jonction tunnel selon l'invention. En d'autres termes, un point mémoire de type MRAM à écriture contrôlée en tension comprenant une jonction tunnel magnétique selon l'invention et défini à la revendication 14. Un autre objet de l'invention défini à la revendication 15, est un composant ou circuit logique non volatile comprenant au moins une jonction tunnel selon l'invention. Un autre objet de la présente invention défini à la revendication 16, est une méthode de fabrication d'une jonction tunnel magnétique dans laquelle la couche de stockage épaisse est gravée par gravure ionique réactive, cette couche de stockage servant alors de masque dur pour la gravure du reste de la jonction tunnel par gravure ionique.

## BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- Figure 1a : Représentation schématique d'un empilement de STT-MRAM avec simple barrière de MgO et une électrode supérieure non-magnétique selon l'état de l'art ;
- Figure 1b : Représentation schématique d'un empilement de STT-MRAM standard avec double barrière de MgO et une électrode supérieure non-magnétique selon l'état de l'art ;
- Figure 2 : Evolution en température du facteur de stabilité thermique de p-STT-MRAM de l'état de l'art à aimantation hors du plan pour des jonctions tunnel de diamètre entre 100nm et 44nm ;
- Figure 3 : Dépendance en température de l'anisotropie interfaciale de premier ordre (uniaxial en $\sin^2 \theta$, $\theta$ angle entre l'aimantation de la couche de stockage et la normale au plan des couches) et de second ordre (en $\sin^4 \theta$) de multicouches W/CoFeB/MgO avec différentes épaisseurs de CoFeB. Tiré de Kyoung-Min Lee et al., "Temperature dependence of the interfacial magnetic anisotropy in W/CoFeB/MgO", AIP Advances 7, 065107 (2017) ;
- Figure 4 : Variation thermique de l'aimantation du cobalt massif ;
- Figure 5 : Facteur de stabilité thermique (en niveaux de gris) en fonction du diamètre et de l'épaisseur de la couche de stockage ;
- Figure 6 : Représentation schématique de trois exemples d'une jonction tunnel magnétique PSA-STT-MRAM selon l'invention ;
- Figure 7 : Représentation schématique de la jonction tunnel magnétique selon un exemple PSA-MRAM-1 ;
- Figure 8 : Représentation schématique de la jonction tunnel magnétique selon un premier mode de réalisation PSA-MRAM-2 de l'invention ;
- Figure 9 : Energie de barrière en fonction de la température entre -40 et +260 °C pour 4 MRAM différentes: Fe-CoB(1.2nm) avec D = 31 nm, FeCoB(1.4nm)/Co(12nm) avec D = 12.8 nm, Co(16.6nm) avec D = 11.4 nm et Py(26.8nm) avec D = 19 nm.
- Figure 10 : Implémentation de la jonction tunnel selon l'invention dans une cellule mémoire de SOT-MRAM ; a) Configuration « top » ; b) Configuration « bottom » ;
- Figure 11 : Implémentation de la jonction selon l'invention dans une MRAM contrôlée par tension VC-MRAM. La configuration bottom est aussi possible ;
- Figure 12 : Exemple de composant logique non volatile utilisant des jonctions tunnel selon l'invention. Ici une latch non volatile ;
- Figure 13 : Procédé de fabrication d'une jonction tunnel selon l'invention ;
- Figure 14a : Graphiques de $M_S^{FM\ opti}$ and $t^{FM\ opti}$ calculés pour une anisotropie magnétocristalline de $K_u^{FM} = 0$ ; ces courbes correspondent à l'empilement FM monocouche, pour une stabilité $\Delta_{300} = 60$ ;
- Figure 14b : Identique à Fig. 14.a à l'exception près que l'anisotropie magnétocristalline vaut $K_u^{FM} = 0.3\ 10^6$ J/m$^3$ ;
- Figure 14c : Graphiques de $M_S^{FM\ opti}$ (échelle verticale de droite) and $t^{FM\ opti}$ (échelle verticale de gauche) calculés pour une anisotropie magnétocristalline de $K_u^{FM} = 0$. Ces courbes correspondent à l'empilement FeCoB/FM avec $M_S^{FeCoB} = 1.0\ 10^6$ A/m, $t^{FeCoB} = 1.4$ nm et $K_S^{FeCoB} = 1.4$ mJ/m$^2$, pour une stabilité $\Delta_{300} = 60$ ;
- Figure 14d : Identique à Fig. 14.c à l'exception près que l'anisotropie magnétocristalline vaut $K_u^{FM} = 0.3\ 10^6$ J/m$^3$ ;
- Figure 15 : Représentation de $\Delta$ en fonction du diamètre pour tout $M_S$ (code couleur) et pour différents épaisseurs L (axes de couleur). Diagramme calculé à partir du modèle macrospin pour un cylindre avec $K_S = 0$ J/m$^2$ et $K_u = 0$ J/m$^3$ ;

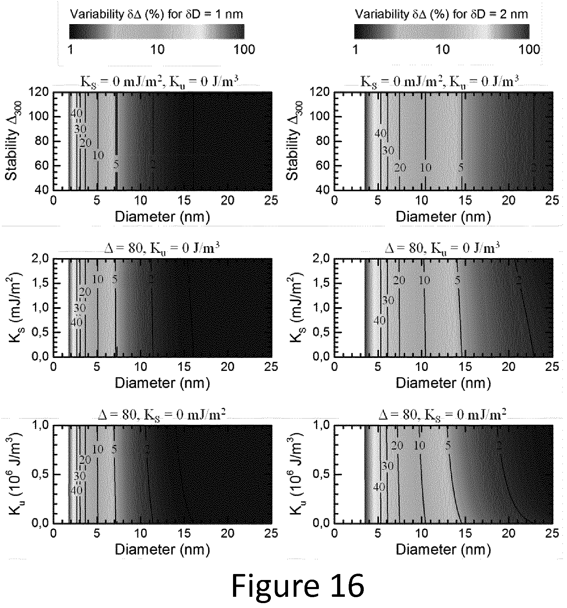

- Figure 16 : Graphiques représentant en code couleur la variabilité du facteur de stabilité thermique (et donc aussi du courant d'écriture) en fonction du diamètre de la cellule pour deux variabilités données du diamètre de la cellule (variabilité associée au procédé de gravure : $\delta D=1nm$ colonne de gauche, $\delta D=2nm$, colonne de droite). Sur ces figures, 3 paramètres ont été variés $\Delta$, $K_s$ et $K_u$. Les échelles verticales représentent chacune un de ces paramètres, les deux autres étant fixés. Pour chaque ensemble de valeurs de paramètres $\Delta$, $K_s$ et $K_u$, D, l'épaisseur L et l'aimantation $M_S$ sont choisies pour correspondre aux paramètres optimaux $\{L^{opti}, M_S^{opti}\}$.

## DESCRIPTION DETAILLEE DE L'INVENTION

Sauf précision contraire, un même élément apparaissant sur des figures différentes présente une référence unique.

La figure 6 représente schématiquement trois exemples de jonction tunnel magnétique PSA-STT-MRAM selon l'invention.

Selon la variante a), la jonction tunnel selon l'invention comprend une couche de référence d'aimantation fixe hors du plan RL, une barrière tunnel TB et une couche de stockage SL présentant un rapport de forme vertical épaisseur/(dimension caractéristique planaire) compris entre 0.8 et 8. La couche de référence RL présente une aimantation perpendiculaire fixe représentée par une flèche simple. La couche de stockage présente une aimantation perpendiculaire commutable entre deux états d'aimantation normale au plan des couches, représentée par une flèche double. Dans la configuration a) dite « top », la couche de stockage SL est au-dessus de la barrière tunnel TB et la couche de référence RL en dessous. Dans la configuration b) dite « bottom », la couche de stockage est en dessous de la barrière tunnel TB et la couche de référence RL au-dessus. Pour des raisons de qualité de croissance et de facilité de fabrication, la configuration a) est préférable dans la mesure du possible.

La configuration de la figure 6 c) représente une jonction tunnel aussi selon l'invention dans laquelle les flancs de la jonction sont légèrement inclinés au lieu d'être quasiment verticaux. Cette forme avec flancs inclinés peut provenir de la gravure de la jonction par gravure par faisceau d'ions (IBE). Même si quantitativement l'anisotropie de forme de la couche de stockage SL est modifiée à cause de cette forme tronconique, une anisotropie de forme verticale peut aussi être obtenue et les autres paramètres peuvent être adaptés à cette forme par l'homme de l'art selon la présente invention.

Le matériau ferromagnétique constitutif de la couche de stockage SL et la forme de cette couche (épaisseur et dimension latérale) sont choisis de sorte que l'anisotropie de forme de la couche de stockage SL est positive et supérieure à l'anisotropie interfaciale existant à l'interface avec la barrière tunnel. Deux configurations peuvent être utilisées. Dans la configuration a) dite « top », la couche de stockage est au-dessus de la barrière tunnel et la couche de référence en dessous. Dans la configuration b) dite « bottom », la couche de stockage est en dessous de la barrière tunnel et la couche de référence au-dessus. Pour des raisons de qualité de croissance et de facilité de fabrication, la configuration a) est préférable dans la mesure du possible.

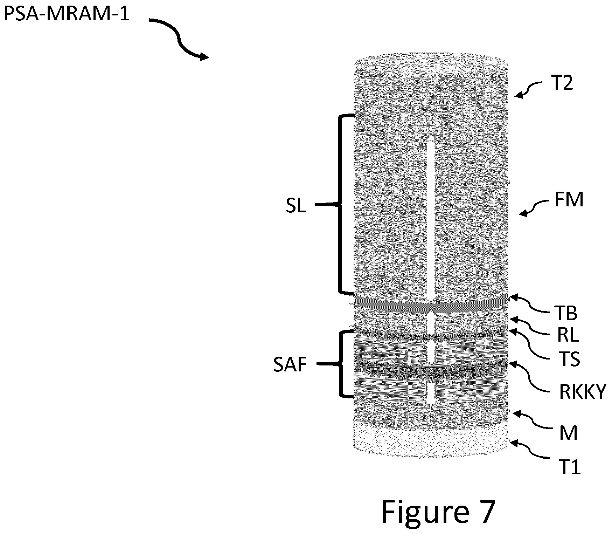

La figure 7 décrit un exemple d'une jonction tunnel magnétique ou PSA-MRAM-1 dans laquelle la couche de stockage SL est composée d'une couche ferromagnétique FM unique c'est-à-dire constituée d'un seul matériau homogène.

La jonction tunnel illustrée à la figure 7 comprend de bas en haut :

- une couche de contact électrique inférieur T1,
- une couche de croissance métallique M ,
- un élément synthétique antiférromagnétique SAF constitué de deux couches ferromagnétiques couplées antiferromagnétiquement à travers une couche de couplage RKKY par exemple de Ru d'épaisseur 0.3nm à 0.8nm d'épaisseur,
- une couche de transition structurale TS apte à absorber le bore, par exemple en Ta ou W,
- une couche de référence typiquement en CoFeB d'épaisseur 1 à 3nm,
- une barrière tunnel le plus souvent en MgO d'épaisseur entre 0.6 et 2nm,
- la couche de stockage présentant un rapport de forme allongé verticalement, la couche de stockage étant formée d'un matériau homogène donnant une forte magnétorésistance tunnel et de préférence à faible amortissement de Gilbert tel qu'un alliage à base de Co, de Fe et de B. Cette couche FM est surmontée d'une couche métallique permettant d'absorber l'élément amorphisant (ici le B) et aussi servant de contact électrique supérieur et éventuellement de masque dur pendant la gravure du point mémoire.

La configuration symétrique « bottom » est également possible.

En partant de sa base, la jonction tunnel PSA-MRAM-1 comprend sur un substrat T1 une couche d'accroche et de croissance M destinée à favoriser l'adhérence de la jonction tunnel sur son substrat et à promouvoir une bonne texture de croissance pour la suite de la jonction. Elle comprend ensuite une couche antiferromagnétique synthétique SAF bien connue de l'homme de l'art, constituée de deux couches ferromagnétiques dont les aimantations sont couplées antiparallèlement à travers une fine couche RKKY assurant un couplage antiparallèle entre les aimantations des couches ferromagnétiques. Cette couche de couplage est constituée d'un matériau tel que le ruthénium ou l'iridium d'épaisseur convenablement choisie pour que le couplage soit antiparallèle. Par exemple, pour le ruthénium, les épaisseurs donnant un couplage antiparallèle sont typiquement entre 0.3nm et 0.8nm. Les couches ferromagnétiques sont constituées de multicouches telles que (Co/Pt) ou (Co/Pd) ou d'alliages CoPt ou CoPd ou d'alliages ordonnés L10 de type FePt ou FePd connus pour avoir une anisotropie magnétique hors du plan. Cette multicouche antiferromagnétique synthétique SAF est surmontée d'une fine couche métallique nanocristallisée TS typiquement en Ta, Hf, W ou Mo ayant plusieurs buts : 1) assurer une transition structurale entre la multicouche synthétique antiferromagnétique généralement de structure cubique face centrée (fcc) de symétrie d'ordre 3 dans la direction de croissance privilégiée (111) et la couche d'alliage CoFeB en contact avec la barrière tunnel qui est de structure cubique centrée donc de symétrie d'ordre 4 ; 2) absorber le bore ou l'élément amorphisant si celui-ci est autre que le bore (par exemple Zr, Nb...) hors de la couche de CoFeB en contact avec la barrière tunnel de MgO lors du recuit post-dépôt nécessaire à la bonne cristallisation de la barrière de MgO et de ses électrodes. Cette couche est suffisamment fine (typiquement entre 0.2nm et 0.4nm) pour fournir un fort couplage ferromagnétique entre la multicouche antiferromagnétique synthétique et la couche de CoFeB.

Cette couche de transition structurale TS est elle-même surmontée d'une couche d'alliage CoFeB d'épaisseur typiquement entre 1 et 2nm qui constitue l'électrode de référence RL de la jonction tunnel. L'aimantation de cette couche reste fixe hors du plan pendant l'opération de la mémoire.

Cette couche est surmontée par la barrière tunnel TB de MgO d'épaisseur typique de 0.6 à 2nm. Cette épaisseur permet de contrôler le produit résistance x surface (RA) de la jonction. Dans les STT-MRAM, ce produit RA est généralement choisi entre 1 et 10 $\Omega.\mu m^2$ pour que la jonction tunnel ait une résistance comparable à celle du transistor de sélection en mode passant qui est connecté à la jonction tunnel.

La barrière tunnel TB est surmontée par l'électrode magnétique de stockage SL constituée dans ce premier mode de réalisation d'une couche unique de matériau magnétique réalisé en alliage à base de Co, de Fe, de Ni et d'un élément amorphisant, de préférence le bore mais d'autres éléments amorphisants pourraient être utilisés comme le Zr ou le Nb. L'épaisseur de cette couche sera choisie entre 0.5 et 8 fois le diamètre visé pour la jonction tunnel après nanostructuration. L'alliage sera choisi avec une température de Curie supérieure à 400°C et de préférence supérieure à 600°C voire 800°C pour que la variation de son aimantation sur la gamme -40°C à 260°C ne soit pas trop importante. Une façon d'augmenter la température de Curie de l'alliage est d'augmenter sa concentration en cobalt dont la température de Curie est de 1121°C. Toutefois, l'amortissement de Gilbert dépend de la concentration de l'alliage, étant minimum vers des concentrations ou le fer est en proportion 3 fois plus grande que le cobalt (Ultra-low magnetic damping of a metallic ferromagnet, Martin A.W. Schoen Danny Thonig, Michael L. Schneider, T. J. Silva, Hans T. Nembach, Olle Eriksson, Olof Karis and Justin M. Shaw, Nat.Phys.12, 839 (2016)). Comme l'amortissement de Gilbert influe directement sur le courant d'écriture, il faudra choisir la concentration de l'alliage à la fois en fonction du besoin pour minimiser la variation thermique et de la tolérance sur la valeur du courant d'écriture.

Cette couche ferromagnétique est surmontée par une ou plusieurs couches métalliques T2. Un premier but de cette couche métallique est d'absorber l'élément amorphisant hors de l'électrode magnétique de stockage lors du recuit post-dépôt nécessaire à la bonne cristallisation de la barrière tunnel et des électrodes magnétiques. Cette couche apte à absorber l'élément amorphisant peut être réalisée en tantale (Ta), tungsten (W), molybdene (Mo), Hafnium (Hf) etc. Eventuellement, plusieurs laminations de cette couche apte à absorber le bore ou l'élément amorphisant peuvent être introduites dans l'épaisseur de la couche ferromagnétique de stockage pour améliorer la recristallisation de l'alliage. Par exemple une couche de CoFeB 16nm surmontée d'une couche de Mo de 4nm pourra être remplacée par une mutlicouche (CoFeB 4nm/Mo 2nm)$_4$/Mo 2nm.

La couche ferromagnétique de stockage SL peut aussi être surmontée d'une deuxième couche d'oxyde (deuxième barrière tunnel) destinée à renforcer l'anisotropie perpendiculaire de la couche de stockage. Dans ce cas, en plus de l'anisotropie de forme de la couche de stockage, celle-ci bénéficie aussi de l'anisotropie d'interface non seulement à l'interface avec la barrière tunnel mais aussi à l'interface avec cette deuxième couche d'oxyde. Il faut veiller alors à ce qu'une ou plusieurs couches aptes à absorber l'élément amorphisant de la couche de stockage soient insérées dans la couche de stockage comme décrit précédemment. Comme il est connu de l'homme de l'art, la deuxième barrière tunnel doit avoir un produit résistance surface suffisamment faible par rapport à la première barrière tunnel qui fournit le signal de magnétorésistance tunnel pour ne pas trop réduire ce signal du fait de la résistance en série associée avec cette deuxième barrière tunnel.

D'autres fonctions de la ou des couches métalliques supérieures T2 sont de permettre un contact électrique au sommet de la structure et éventuellement de servir de masque dur de gravure lors de la gravure de la jonction tunnel.

La structure décrite sur la Figure 7 est présentée en configuration « top ». Il va de soi que la configuration « bottom » peut aussi être réalisée en inversant l'empilement c'est-à-dire avec la couche de stockage sous la barrière tunnel et la couche de référence en la couche de SAF au-dessus de la barrière.

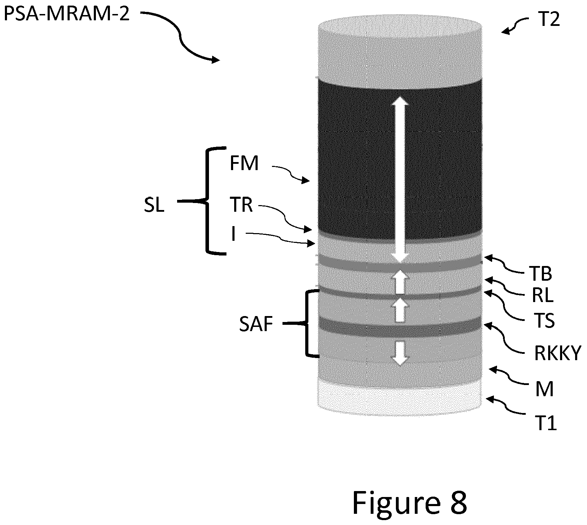

La figure 8 illustre une jonction tunnel magnétique PSA-MRAM-2 selon un premier mode de réalisation de l'invention.

La jonction magnétique tunnel PSA-MRAM-2 selon l'invention comprend de bas en haut :

- Une couche de contact électrique inférieur T1 ;
- une couche de croissance métallique M ;
- un synthétique antiferromagnétique SAF constitué de deux couches ferromagnétiques couplées antiferromagnétiquement à travers une couche de couplage RKKY par exemple de Ru d'épaisseur 0.3nm à 0.8nm d'épaisseur ;
- une couche de transition structurale TS apte à absorber le bore par exemple en Ta ou W ;
- une couche de référence RL typiquement en CoFeB ;
- une barrière tunnel TB le plus souvent en MgO ;
- une couche de stockage SL présentant un rapport de forme allongé verticalement, la couche de stockage étant formée d'une partie interfaciale I par exemple en FeCoB, d'une fine couche de transition TR, par exemple en Ta ou W ou Mo et d'une couche épaisse ferromagnétique FM
- une couche métallique T2 servant de contact électrique supérieur et éventuellement de masque dur pendant la gravure du point mémoire.

La configuration symétrique « bottom » est également possible.

Dans le mode de réalisation décrit sur la figure 8, la couche de stockage SL, au lieu d'être constituée d'un matériau homogène, est constituée d'un ensemble de couches magnétiques et non magnétiques. En particulier, si la barrière tunnel est en MgO comme c'est le cas le plus souvent, il est avantageux de conserver près de l'interface avec la barrière tunnel TB une couche I d'alliages CoFeB riche en cobalt pour réduire l'anisotropie interfaciale, de 1.5 à 3nm d'épaisseur, permettant d'obtenir une forte magnétorésistance tunnel. Comme exemple non limitatif d'alliages riches en Co on peut citer :

$Co_{80}B_{20}$ ;
$Co_{72}Fe_8B_{20}$ ;
$Co_{56}Fe_{24}B_{20}$ ;

ou plus généralement : $(Co_xFe_{(1-x)})_{(1-y)}B_y$ avec x compris entre 0.5 et 1 et y compris entre 0 et 0.40, le bore pouvant être substitué tout ou partie par un autre élément amorphisant (par exemple Zr, Nb, V) et le Fe pouvant être partiellement substitué par du Nickel.

Cette fine couche magnétique peut être associée à une couche épaisse de NiFe ou d'alliages à base de Co, Fe, Ni et éventuellement d'autres additifs (V, Al, Mo...) présentant un faible amortissement de Gilbert. Cette couche est notée FM. Avantageusement, les deux couches magnétiques sont séparées par une couche non magnétique TR par exemple de Mo, W, Hf ou Ta de 0.2 à 0.4nm d'épaisseur permettant d'absorber le bore de la couche de CoFeB lors du recuit post-dépôt nécessaire à la bonne cristallisation de la barrière de MgO et des électrodes de CoFeB comme cela est connu dans les STT-MRAM de l'état de l'art.

Dans le premier mode de réalisation décrit sur la Figure 8, la couche de stockage ferromagnétique épaisse SL comprend au moins deux matériaux magnétiques différents. Le premier matériau magnétique en contact avec la barrière tunnel permet d'obtenir une forte magnétorésistance tunnel. Par forte magnétorésistance tunnel, on entend une magnétorésistance au moins supérieure à 100%. Comme dans les p-STT-MRAMs conventionnelles, cette couche interfaciale I sera préférentiellement en alliage à base de Co, de Fe et de B ou autre élément amorphisant. Comme dans la présente invention, on cherche à réduire le rôle relatif de l'anisotropie d'interface, on choisira ici un alliage interfacial riche en cobalt car il est connu que l'anisotropie à l'interface Co/MgO est plus faible qu'à l'interface Fe/MgO.

Comme exemple non limitatif d'alliages riches en Co on peut citer :

$Co_{80}B_{20}$ ;
$Co_{72}Fe_8B_{20}$ ;
$Co_{56}Fe_{24}B_{20}$ ;

ou plus généralement : $(Co_xFe_{(1-x)})_{(1-y)}B_y$ avec x compris entre 0.5 et 1 et y compris entre 0 et 0.40, le bore pouvant être substitué tout ou partie par un autre élément amorphisant (par exemple Zr, Nb, V) et le Fe pouvant être partiellement substitué par du Nickel.

Un deuxième matériau magnétique FM est alors déposé dans la partie de la couche de stockage plus éloignée de la barrière tunnel. Ce deuxième matériau est choisi pour avoir un faible amortissement de Gilbert $\alpha$. Par faible amortissement de Gilbert, on entend un amortissement inférieur à 0.02. En effet, le courant nécessaire à l'écriture par STT étant proportionnel à l'amortissement de Gilbert moyenné sur tout le volume de la couche, il est préférable de minimiser cet amortissement moyen. Des matériaux à faible amortissement de Gilbert sont le Permalloy ($Ni_{80}Fe_{20}$), des alliages CoFe de concentration proche de $Co_{25}Fe_{75}$, des alliages d'Heusler. Ces deux matériaux magnétiques pouvant avoir des structures cristallographiques différentes, une couche de transition structurale TS apte à absorber l'élément amorphisant lors de recuit post-dépôt pourra être introduit entre les deux couches des deux matériaux magnétiques comme représenté sur la Figure 8.

Grace à ce choix de matériau à l'interface avec la barrière tunnel TB et dans le volume de la couche de stockage SL, on cherchera à ce que l'anisotropie de forme soit au moins 2 fois plus forte et de préférence 4 fois plus forte que l'anisotropie d'interface pour réduire la dépendance en température de l'anisotropie totale.

Les autres couches constitutives de l'empilement sont similaires à celles discutées pour l'exemple de la Figure 7.

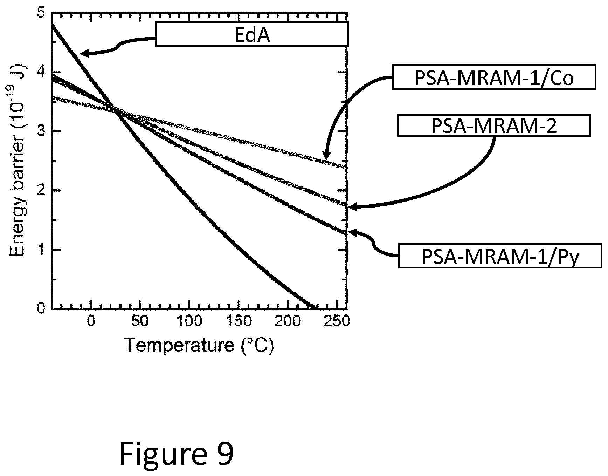

La Figure 9 illustre la variation thermique du facteur de stabilité thermique dans des jonctions tunnels de l'état de l'art et dans celles selon la présente invention.

La figure 9 montre la variation thermique de la hauteur de barrière $E_b$ qui détermine la valeur du facteur de stabilité thermique $\Delta = E_b/k_B T$, pour différents types de couches de stockage selon l'exemple de la Figure 7 (couche de stockage entièrement en Co, PSA-MRAM-1/Co, ou entièrement en NiFe, PSA-MRAM-1/Py), pour le premier mode de réalisation (Couche interfaciale de FeCoB associée à une couche volumique épaisse en cobalt, PSA-MRAM-2) et pour une couche de stockage selon l'état de l'art (EdA).

Le bénéfice obtenu de cette invention en termes de variation thermique du facteur de stabilité thermique ressort clairement sur la figure 9.

Dans le paragraphe ci-dessous, les variations thermiques des facteurs de stabilité thermique illustrées à la figure 9 sont comparées sur la base de modélisation pour différentes compositions de couches de stockage suivant l'exemple de la Figure 7 et le premier mode de réalisation et pour une couche de stockage suivant l'état de l'art.

Dans cette comparaison, la variation d'aimantation en fonction de la température est décrite par :

$$M_S(T) = M_S(0)\left[1 - \left(\frac{T}{T_c}\right)^{\frac{3}{2}}\right]$$

où $M_S(0)$ est l'aimantation à 0 K. La variation d'anisotropie est donnée par :

$$K(T) = K(0)\left(1 - b\frac{T}{T_c}\right)\left[\frac{M_S(T)}{M_S(0)}\right]^3$$

où $K(0)$ est l'anisotropie à 0 K. Le terme b représente un coefficient de dilatation thermique, utile pour tenir compte de la dilatation du réseau cristallin des couches minces. Ainsi, on prendra b = 0 pour des couches épaisses (L > 5 nm) et b = 0.4 pour des couches minces (L < 5 nm). Lorsque la couche de stockage est composée de plusieurs couches ferromagnétiques couplées entres elles, une propriété X (X = $M_S$, $K_S$, $K_u$, a) de la couche dans son ensemble est donnée par :

$$\begin{cases} L = \sum_i L^i \\ X = \sum_i X^i \frac{L^i}{L} \end{cases}$$

où l'indice i fait référence à la couche i. De plus, les valeurs numériques suivantes ont été utilisées :

- $M_S^{Co}(0) = 1.6\ 10^6$ A/m, A/m, aimantation à 0 K du Co massif.

- $M_S^{FeCoB}(0) = 1.6\ 10^6$ A/m, A/m, aimantation à 0 K du FeCoB couche mince.

- $M_S^{Py}(0) = 0.9\ 10^6$ A/m, aimantation à 0 K du Permalloy (Py) massif.

- $K_S^{FeCoB}(0) = 3$ mJ/m$^2$ , anisotropie à 0 K de MgO/FeCoB couche mince.

- $T_c^{FeCoB} = 1100$ K, température de Curie du FeCoB couche mince.

- $T_c^{Co} = 1388$ K, température de Curie du Co massif.

- $T_c^{Py} = 826$ K, température de Curie du Permalloy.

Les variations thermiques de la hauteur de barrière ont été étudiées entre -40°C et +260°C pour couvrir à la fois le domaine des applications automobiles et aussi la question de la rétention de la mémoire au moment de la soudure de la puce (solder reflow compliance). Dans cette comparaison, les valeurs de diamètres et épaisseurs sont choisies de sorte que chaque dispositif possède une stabilité thermique $\Delta$ = 80 à 300 K.

L'état de l'art EdA correspond à l'empilement FeCoB(1.2nm) avec D = 60 nm. On constate que, dans ces conditions, l'anisotropie perpendiculaire varie extrêmement rapidement et qu'en particulier elle n'est plus maintenue au-delà de ~230 °C.

- Les deux cas de l'exemple de la Figure 7 PSA-MRAM-1/Co et PSA-MRAM-1/Py correspondent respectivement aux empilements Co(16.6nm) avec D = 11.4 nm et Py(26.8nm) avec D = 19 nm. Dans ces cas, l'anisotropie varie beaucoup plus lentement comparé à l'état de l'art, en particulier dans le cas du Co qui possède une température de Curie très élevée (1121°C).
- Le cas du premier mode de réalisation PSA-MRAM-2 correspond à l'empilement FeCoB(1.4nm)/Co(12nm) avec D = 12.8 nm. La dépendance de son anisotropie est logiquement comprise entre celle du Co pur et celle de l'état de l'art puisque qu'il s'agit d'un mixe entre les deux technologies.

Les PSA-MRAM décrites dans la présente demande présentent donc une dépendance de leur anisotropie en fonction de la température beaucoup plus faible que celle de l'état de l'art. Afin de minimiser cette dépendance, il est préférable d'utiliser le premier mode de réalisation et de choisir pour la partie volumique de la couche de stockage des matériaux à forte température de Curie comme le fer ou le cobalt ou des alliages contenant une grande proportion de ces matériaux, en particulier de cobalt tout en veillant à ce que l'amortissement de Gilbert du matériau choisi ne soit pas trop grand, c'est-à-dire reste typiquement inférieur à 0.02. En ce qui concerne le matériau interfacial de la couche de stockage en contact avec la barrière tunnel, on choisira un matériau interfacial présentant une faible anisotropie de surface puisque l'anisotropie de surface varie plus rapidement en température que l'anisotropie de forme. Ceci est réalisable avec des alliages à base de Co et de Fer et d'élément amorphisant comme le bore, riches en Co car l'anisotropie à l'interface oxyde/cobalt est plus faible qu'à l'interface oxyde/Fe.

Comme exemple non limitatif d'alliages riches en Co on peut citer :

$Co_{80}B_{20}$ ;
$Co_{72}Fe_8B_{20}$ ;
$Co_{56}Fe_{24}B_{20}$ ;

ou plus généralement : $(Co_xFe_{(1-x)})_{(1-y)}B_y$ avec x compris entre 0.5 et 1 et y compris entre 0 et 0.40, le bore pouvant être substitué tout ou partie par un autre élément amorphisant (par exemple Zr, Nb, V) et le Fe pouvant être partiellement substitué par du Nickel.

Cet alliage interfacial sera choisi pour fournir une forte amplitude de TMR comme c'est le cas avec les alliages CoFeB. Comme décrit précédemment, ces deux matériaux magnétiques pourront être séparés par une fine couche de matériau comme du Ta, W ou Mo, apte à absorber l'élément amorphisant et à assurer une transition structurale entre les deux matériaux. Eventuellement, la couche de stockage peut contenir plusieurs laminations d'un tel matériau apte à absorber l'élément amorphisant.

Dans le cas où la couche de stockage est insérée entre deux barrières tunnels, alors la couche de stockage pourra être divisée en 3 parties, une première couche magnétique interfaciale au contact de la première barrière de même nature que décrite ci-dessus dans le cas d'une seule barrière, surmontée d'une deuxième couche magnétique volumique de même nature que décrite ci-dessus dans le cas d'une seule barrière tunnel, surmontée d'une deuxième couche magnétique interfaciale au contact de la deuxième barrière tunnel présentant elle aussi une faible anisotropie d'interface. Ces différentes couches magnétiques pourront être séparées par plusieurs couches de matériau comme du Ta, W ou Mo, apte à absorber l'élément amorphisant et à assurer une transition structurale d'un matériau à l'autre. Notons que l'utilisation de deux barrières tunnel présentent ici un intérêt limité dans la mesure où la deuxième barrière tunnel utilisée dans l'état de l'art sert à augmenter l'anisotropie perpendiculaire d'origine interfaciale grâce à la présence de deux interfaces oxyde/métal magnétique alors que dans la présente invention, on cherche au contraire à réduire la contribution des interfaces à l'anisotropie totale. Dans la présente invention, il sera donc en général préférable de se limiter à une seule barrière tunnel.

Dans un second mode de réalisation, la jonction tunnel magnétique selon l'invention est intégrée dans une cellule de SOT-MRAM.

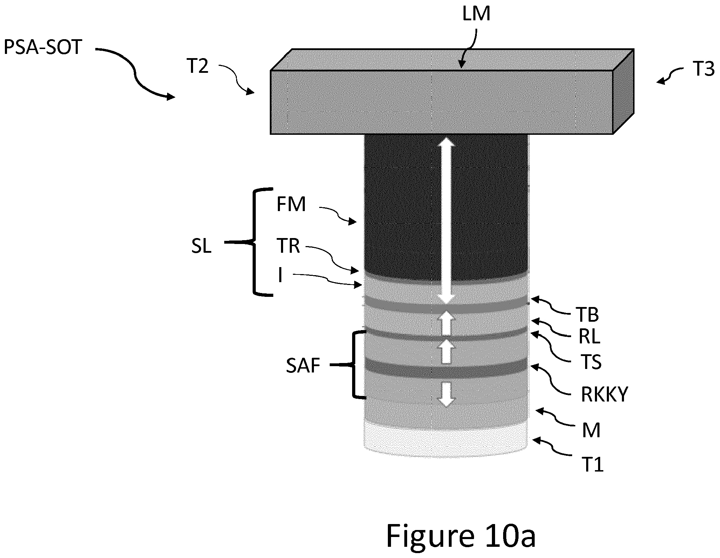

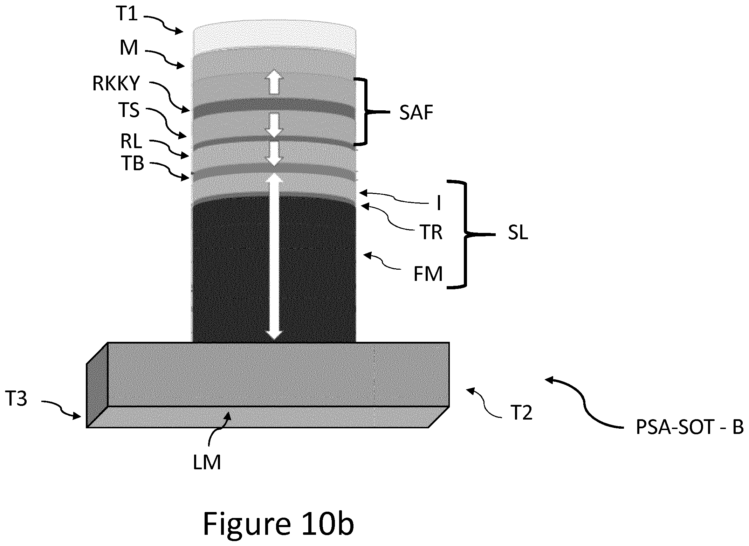

Le dispositif peut être réalisé en configuration « top », illustré à la figure 10a ou « bottom » illustré à la Figure 10b.

La jonction magnétique PSA-SOT selon l'invention illustrée à la figure 10a comprend de bas en haut :

- une couche de contact électrique inférieur ou terminal T1 ;
- une couche de croissance métallique M ;
- une couche synthétique antiferromagnétique SAF constitué de deux couches ferromagnétiques couplées antiferromagnétiquement à travers une couche de couplage RKKY par exemple de Ru d'épaisseur 0.3nm à 0.8nm d'épaisseur,
- une couche de transition structurale TS apte à absorber le bore par exemple en Ta ou W,
- une couche de référence RL typiquement en CoFeB,
- une barrière tunnel TB le plus souvent en MgO,
- une couche de stockage SL présentant un rapport de forme allongé verticalement, la couche de stockage étant formée d'une partie interfaciale I par exemple en FeCoB, d'une fine couche de transition TR, par exemple en Ta ou W ou Mo et d'une couche épaisse ferromagnétique FM.

une ligne métallique LM parallèle au plan des couches et au contact de la couche de stockage SL et comportant un deuxième contact électrique ou terminal T2 et un troisième contact électrique ou terminal T3. Comme il est connu de l'homme du métier, les cellules de SOT-MRAM ont 3 terminaux, T1, T2 et T3. Lors de l'écriture, l'aimantation de la couche de stockage SL est commutée en faisant circuler une impulsion de courant dans une ligne conductrice LM parallèle au plan des couches. Le matériau de la ligne conductrice LM est choisi pour avoir un fort angle de Hall de spin. Cette ligne peut être par exemple en métal non-magnétique tel que Pt, Ta, W, Ir ou en métal antiferromagnétique comme IrMn ou PtMn ou autre matériau lourd à fort spin orbite. Un effet spin orbite appelé effet Hall de spin se produisant dans cette ligne conductrice LM permet d'injecter un courant polarisé en spin dans la couche de stockage SL. Ce courant de spin permet de faire commuter l'aimantation de la couche de stockage SL. Comme il est connu de l'homme de l'art, lorsque l'aimantation de la couche de stockage SL est hors du plan, il est nécessaire d'appliquer un champ longitudinal statique (sensiblement parallèle à la ligne conductrice) pour rendre la commutation déterministe. Ce champ peut être créé en insérant à la base ou au sommet de l'empilement une couche de matériau dur rayonnant un champ statique sur la couche de stockage ou en utilisant le champ d'anisotropie d'échange produit à l'interface entre la couche de stockage et la ligne conductrice de métal lourd lorsque celle-ci est antiferromagnétique comme décrit dans l'article : S.Fukami, C.Zhang, S.Dutta Gupta, A.Kurenkov and H.Ohno, Magnetization switching by spin-orbit torque in an antiferromagnet-ferromagnet bilayer system, Nat.Mat.15, 535 (2017).

Le dispositif peut être réalisé en configuration top (Figure 10a) ou bottom (Figure 10b).

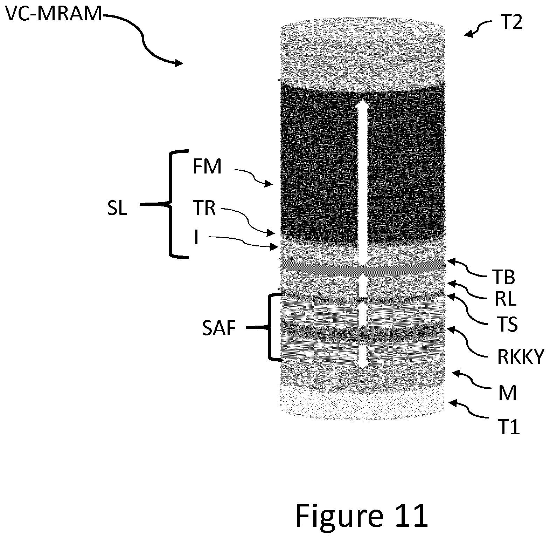

Dans un troisième mode de réalisation, la jonction tunnel magnétique est utilisée dans une cellule MRAM à écriture contrôlée en tension. Une telle jonction tunnel à écriture contrôlée par tension électrique VC-MRAM est illustrée sur la figure 11.

La jonction tunnel à écriture contrôlée par tension électrique VC-MRAM selon l'invention comprend de bas en haut :

- une couche de contact électrique inférieur T1 ;
- une couche de croissance métallique M ;
- une couche synthétique antiferromagnétique SAF constitué de deux couches ferromagnétiques couplées antiferromagnétiquement à travers une couche de couplage RKKY par exemple de Ru d'épaisseur 0.3nm à 0.8nm d'épaisseur,
- une couche de transition structurale TS apte à absorber le bore par exemple en Ta ou W,
- une couche de référence RL typiquement en CoFeB,
- une barrière tunnel TB le plus souvent en MgO,
- une couche de stockage SL présentant un rapport de forme allongé verticalement, la couche de stockage étant formée d'une partie interfaciale I par exemple en FeCoB, d'une fine couche de transition TR, par exemple en Ta ou W ou Mo et d'une couche épaisse ferromagnétique FM.
- une couche métallique T2 servant de contact électrique supérieur et éventuellement de masque dur pendant la gravure du point mémoire. La configuration symétrique « bottom » est également possible.

Comme il est connu de l'homme de l'art, les propriétés magnétiques de certains matériaux magnétiques peuvent être contrôlées par champ électrique. En particulier, l'anisotropie interfaciale à l'interface oxyde/métal magnétique peut être modulée par l'application d'un champ électrique à travers l'oxyde comme décrit par exemple dans : Induction of coherent magnetization switching in a few atomic layers of FeCo using voltage puises, Y.Shiota, T.Nozaki, F.Bonell, S.Murakami, T.Shinjo, and Y. Suzuki, Nature Materials 11, 39 (2012). Egalement, les propriétés volumiques de matériaux magnétiques multiferroïques peuvent être modulées par champ électrique. Ainsi la couche de stockage peut être conçue soit en jouant sur la modulation de l'anisotropie d'interface, soit en jouant sur la modulation d'une aimantation de volume, soit les deux, de sorte que l'application d'une tension aux bornes de la jonction tunnel modifie l'anisotropie de hors du plan à dans le plan initiant une rotation de l'aimantation de hors du plan vers dans le plan. Compte tenu du mouvement précessionel induit par cette rotation initiale, en contrôlant la durée de l'impulsion de tension pour qu'elle soit de l'ordre de la moitié de la période de précession, on peut faire commuter l'aimantation de la direction « vers le haut » à la direction « vers le bas » ou vice versa. La lecture est réalisée sous tension plus faible permettant de mesurer l'état magnétique de la jonction par la magnétorésistance tunnel, la tension étant suffisamment faible pour ne pas perturber l'état magnétique de la jonction. Une telle jonction tunnel à écriture contrôlée par tension électrique est illustrée sur la figure 11. D'une façon générale, ces jonctions ont une épaisseur de barrière légèrement plus grande que dans les jonctions à écriture par transfert de spin pour minimiser le courant circulant à travers la barrière lors de l'écriture.

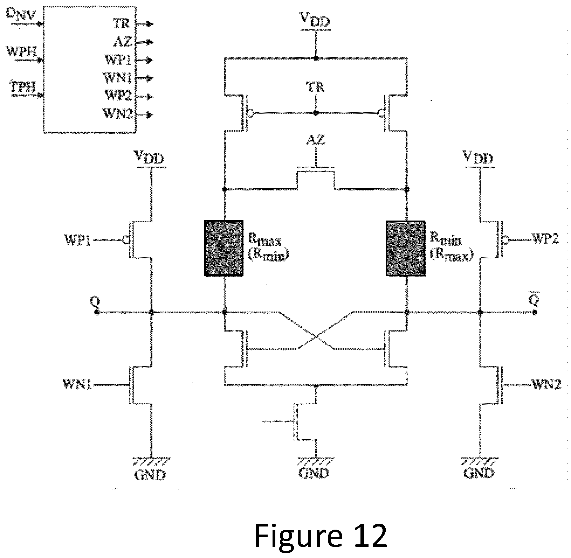

Dans un quatrième mode de réalisation, illustré à la figure 12, la jonction selon l'invention est insérée comme élément non volatile dans un composant logique de différentes natures possibles. Différents composants et circuits logiques non volatiles ont été proposés au cours des dernières années à base de jonctions tunnels conventionnelles utilisant des couches de stockage très fines (1 à 3nm d'épaisseur). Ces mêmes composants et circuits peuvent être réalisés en substituant ces jonctions tunnel de l'état de l'art par les jonctions tunnel selon l'invention. A titre d'exemples, la figure 12 montre une bascule (latch en langue anglaise) non volatile comprenant deux jonctions tunnel magnétiques selon l'invention, représentée en bleue. Ce circuit est adapté de la demande de brevet US2015/0036415 A1.

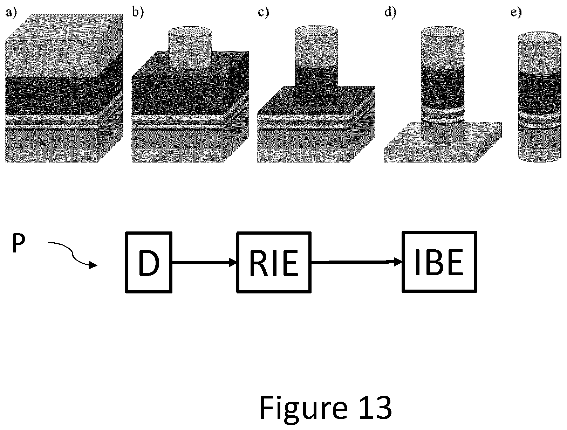

La figure 13 décrit un procédé P de fabrication de la jonction tunnel PSA-MRAM-1 ou PSA-MRAM-2 selon l'invention.

En particulier, la figure 13 illustre: (a) le dépôt de l'ensemble des couches constitutives de l'empilement, (b) la gravure ionique réactive de l'électrode supérieure, (c) la gravure ionique de la couche épaisse FM appartenant à la couche de stockage, (d) une gravure ionique du reste de la jonction tunnel et (e) gravure ionique réactive de l'électrode inférieure ;

Le procédé P selon l'invention comprend les étapes suivantes :

- Dépôt D de l'ensemble des couches par dépôt par phase vapeur ;
- Gravure RIE de la couche de stockage ou couche magnétique épaisse par gravure ionique réactive ;
- Gravure IBE des autres couches par gravure ionique.

Après dépôt de l'ensemble des couches par un procédé de dépôt physique par phase vapeur (PVD) comme la pulvérisation cathodique, on définit par lithographie et gravure un masque dur à la surface de l'empilement. La couche constituant le masque dur peut par exemple être en tantale que l'on grave facilement par gravure ionique réactive.

Ensuite avantageusement, on cherchera à graver la couche magnétique épaisse par gravure ionique réactive. Plusieurs articles décrivent des moyens pour graver le Permalloy ou le cobalt par gravure ionique réactive en utilisant des gaz réactifs à base de méthanol ou de monoxyde de carbone éventuellement combinés avec de l'argon (Developement of methanol based reactive ion etching process for nanoscale magnetic devices, M.T.Moneck and J.G.Zhu, NSTI-Nanotech 2011). Comme cette couche magnétique est épaisse, il est particulièrement avantageux d'essayer de la graver par gravure ionique réactive pour éviter beaucoup de dépôt de ce matériau magnétique gravé. Si la couche magnétique épaisse est constituée de plusieurs éléments magnétiques, on peut alors graver par gravure ionique réactive au moins le plus épais des deux.

Ensuite le reste de la structure peut être gravée par gravure par faisceau d'ion (Ion Beam etching (IBE)) dans la mesure où les couches en jeu sont beaucoup plus fines. Cette méthode est compatible avec des fortes densités de point mémoire (nœud technologique < 10 nm) puisque la gravure de la jonction est presque entièrement réalisée par RIE et que la couche de stockage peut elle-même constituée un masque dur épais pour la gravure de la partie basse de l'empilement.

**Minimisation de la variabilité**

Un autre objet est une jonction tunnel magnétique possédant un facteur de stabilité dépendant de la barrière d'énergie et de la température d'utilisation de la jonction tunnel magnétique dans laquelle la composition et l'épaisseur de la couche de stockage sont choisies de sorte que la valeur absolue de la dérivée du facteur de stabilité thermique par rapport à une dimension caractéristique d'une section planaire de la jonction tunnel soit inférieure à 10 nm$^{-1}$, la dérivée du facteur de stabilité étant calculée à une température $T_m$, la température $T_m$ étant la température moyenne d'utilisation de la jonction tunnel magnétique. Avantageusement, un tel choix des paramètres de la jonction tunnel magnétique permet de réduire la variabilité de point mémoire à point mémoire de l'anisotropie et du courant d'écriture sur une large gamme de température d'opération.

Un exemple de gamme de température est -40 °C à +150°C pour les applications automobiles.

On entend par barrière d'énergie séparant les deux états d'aimantation de la couche de stockage la différence d'énergie entre le minimum d'énergie correspondant à l'état initial stable de l'aimantation de la couche de stockage et le maximum d'énergie rencontré au cours du retournement de l'aimantation vers son état final stable.

On entend par facteur de stabilité thermique une mesure de la stabilité de l'aimantation de la couche de stockage pour une barrière d'énergie et une température donnée.

Par exemple, le facteur de stabilité thermique peut être exprimé comme $\Delta = E_b / K_B T$, $E_b$ étant la barrière d'énergie, T la température et $K_B$ la constante de Boltzmann. On entend par section planaire de la jonction tunnel une section de la jonction tunnel selon le plan des couches formant la jonction tunnel.

On entend par dimension caractéristique d'une section planaire une dimension de ladite section planaire. Par exemple, en cas de jonction tunnel ayant une section circulaire, la dimension caractéristique d'une section planaire de la jonction tunnel peut être choisie comme étant le diamètre du cercle. En cas de section elliptique, la dimension caractéristique peut être choisie comme étant le petit axe ou le grand axe de l'ellipse.

Dans ce qui suit « dimension caractéristique d'une section planaire » et « dimension planaire caractéristique » sont synonymes.

On entend par choix de la composition de la couche de stockage le choix d'au moins un des matériaux compris dans la couche de stockage.

On entend par épaisseur de la couche de stockage la taille de la couche de stockage mesurée selon une direction normale au plan des couches.

Un point important concerne l'optimisation du choix de l'épaisseur et des paramètres magnétiques de la couche de stockage pour minimiser les effets de dispersion des propriétés de point mémoire à point mémoire lors de la fabrication d'une puce mémoire. Parmi les paramètres suivants : diamètre, épaisseur, aimantation à saturation, anisotropie d'interface et anisotropie de volume, principalement le diamètre est susceptible de varier significativement de point mémoire à point mémoire du fait du procédé de gravure ou de nanostructuration des points mémoires. En effet, tous les autres paramètres sont choisis en amont de la gravure des jonctions et ne sont pas affectés par cette dernière. Les techniques de dépôt de l'homme de l'art sont parfaitement maitrisées et n'induisent pas de variations spatiales significatives de ses propriétés au sein d'une puce. En revanche, lors de la gravure des jonctions tunnels, il est inévitable que des variations de diamètre apparaissent d'une jonction à l'autre. Ces variations de diamètre peuvent typiquement être de l'ordre de 1 à quelques nanomètres. Puisque l'anisotropie effective totale puise principalement ou intégralement sa source du terme d'anisotropie de forme, c'est-à-dire liée à la forme même de la couche de stockage, il est inévitable que des variations de diamètre induisent des variations de stabilité thermique, et par conséquent des variations de courant d'écriture. Afin de minimiser l'effet des variations de diamètre sur la stabilité, il est nécessaire de se placer au point défini par

$$min\left(\left|\frac{\partial \Delta}{\partial D}\right|\right)$$ où $min(*)$ représente la fonction minimum et $|*|$ la fonction valeur absolue. En particulier, lorsque cela est possible, il est nécessaire de se placer au point défini par $\frac{\partial \Delta}{\partial D} = 0$.

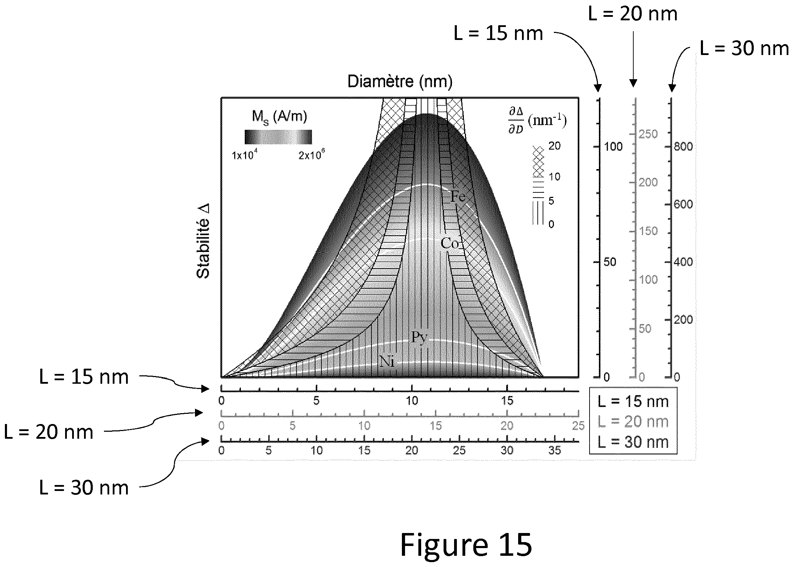

La figure 15 montre $\Delta$ en fonction de D dans l'approximation macrospin, pour un cylindre avec $K_S = 0$ J/m² et $K_u = 0$ J/m³. Ces courbes montrent clairement qu'un maximum de $\Delta(D)$ est toujours atteignable, quel que soit la valeur de l'épaisseur et du $M_S$ de la couche. Se placer autour de ce maximum est avantageux car cela montre que le facteur de stabilité thermique $\Delta$ est alors faiblement dépendant du diamètre exact du pilier constitué par la jonction tunnel magnétique. On peut facilement se convaincre en traçant ces mêmes courbes pour différentes valeurs de $K_S$ et $K_u$ que, dans le régime de fonctionnement des PSA-MRAM, la fonction $\Delta(D)$ présente toujours un unique maximum. Ainsi, même en présence d'anisotropie interfaciale et volumique donnée : $K_S$ et $K_u$, il existe une unique solution optimale { $L^{opti}$, $M_S^{opti}$} qui minimise les effets d'une variabilité de diamètre sur la stabilité, pour une stabilité et un nœud technologique (i.e. un diamètre) prédéfini.

Les calculs ci-dessous présentent une résolution analytique des paramètres { $L^{opti}$, $M_S^{opti}$} dans la limite de l'approximation de l'expression approchée des facteurs démagnétisants d'un cylindre uniformément aimanté évoquée plus haut. Les applications numériques seront faites pour certaines valeurs d'anisotropies $K_S$ et $K_u$ typiquement réalisables avec les matériaux de l'homme de l'art. L'invention ne se limite nullement au cas du cylindre uniformément aimanté ou à des valeurs d'anisotropies choisies en exemple. Afin d'alléger les expressions, des constantes « a », « b » et « c » sont introduites dans l'expression du facteur de stabilité thermique.

$$\Delta = aLD^2\left(1 - \frac{3D}{D+bL}\right) + cD^2(K_uL + K_S)$$

où

$$a = \frac{\pi\mu_0 M_S^2}{16\,k_BT} \quad b = \frac{4}{\sqrt{\pi}} \quad c = \frac{\pi}{4\,k_BT}$$

La condition d'optimisation s'écrit :

$$\frac{\partial\Delta}{\partial D} = \frac{2\Delta}{D} - \frac{3abL^2D^2}{(D+bL)^2} = 0$$

$$\Rightarrow a = \frac{2\Delta(D+bL)^2}{3bL^2D^3}$$

Cette expression de « a » est injectée dans l'expression du facteur de stabilité thermique. Après simplifications, il est possible d'extraire une équation quadratique en L.

$$L^2\left[\frac{1}{2} + \frac{3cD^3K_u}{4b\Delta}\right] + L\left[-\frac{5D}{4b} + \frac{3cD^3K_S}{4b\Delta}\right] - \frac{D^2}{b^2} = 0$$

Parmi les deux racines $L_{\pm}$, seule $L_+$ est positive et correspond donc à l'épaisseur optimale précédemment nommée $L^{opti}$.

$$L^{opti} = \frac{1}{1 + \frac{3cD^3K_u}{2b\Delta}}\left[\frac{5D}{4b} - \frac{3cD^3K_S}{4b\Delta} + \sqrt{\left(\frac{5D}{4b} - \frac{3cD^3K_S}{4b\Delta}\right)^2 + \frac{2D^2}{b^2}\left(1 + \frac{3cD^3K_u}{2b\Delta}\right)}\right]$$

On en déduit $M_S^{opti}$ :

$$M_S^{opti} = \sqrt{\frac{16\,k_BT}{\pi\mu_0}\frac{2\Delta(D+b\,L^{opti})^2}{3b(L^{opti})^2D^3}}$$

A titre d'exemples, on liste quelques exemples de matériaux magnétiques standards ayant une aimantation $M_S^{FM\,opti}$ qui minimisent la variabilité de $\Delta_{300}$ pour des valeurs de diamétre de jonctions entre 10nm et 25nm :

- FM = Cobalt. Une couche de 15 nm de Co ($M_S$ = 1.446 $10^6$ A/m, $K_u$ = 0 J/m$^3$) correspond à la couche optimale pour un diamètre de jonction de D = 10.8 nm.
- FM = Fer. Une couche de 13.4 nm de Fe ($M_S$ = 1.714 $10^6$ A/m, $K_u$ = 0 J/m$^3$) correspond à la couche optimale un diamètre de jonction de D = 9.6 nm.
- FM = Permalloy (Py). Une couche de 23.1 nm de Py ($M_S$ = 0.756 $10^6$ A/m, $K_u$ = 0 J/m$^3$) correspond à la couche optimale un diamètre de jonction de D = 16.6 nm.
- FM = Alliages CoFe. Ces alliages sont optimaux pour des diamètres de jonctions compris entre 10 et 15 nm.
- FM = Co$_2$FeAl (full-Heusler). Une couche d'environ 6 nm de Co$_2$FeAl ($M_S$ = 1.3 $10^6$ A/m, $K_u$ = 0.3 $10^6$ J/m$^3$) correspond à la couche optimale pour des diamètres d'environ 25 nm.

Finalement, dans le cas d'une bicouche comportant une couche d'interface à base de FeCoB dont on suppose les propriétés optimisées pour d'autres raisons (TMR, RA, polarisation en spin, etc) ainsi qu'une couche de volume notée FM, les caractéristiques optimales (épaisseur optimale $L^{FM\,opti}$ et aimantation optimale $M_s^{FM\,opti}$) de la couche FM sont données par :

$$\begin{cases} L^{FM\,opti} & = & L^{opti} - L^{FeCoB} \\ M_S^{FM\,opti} & = & \dfrac{M_S^{opti}\,L^{opti} - M_S^{FeCoB}\,L^{FeCoB}}{L^{opti}} \end{cases}$$

Ce point correspond aux maxima des iso-$M_S$ de la figure 15 ou encore aux minima iso-$\Delta$ de la figure 5.

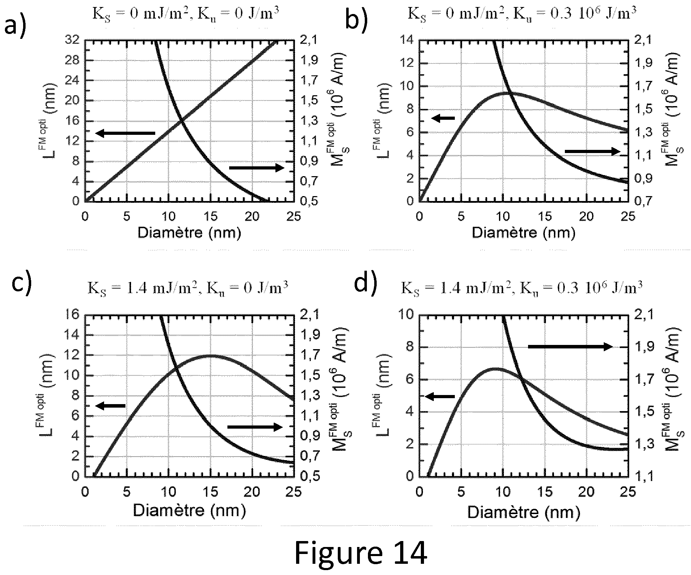

La figure 14 représente $L^{FM\,opti}$ et $M_S^{FM\,opti}$ en fonction du nœud technologique (identifié ici au diamètre du point mémoire) pour une stabilité $\Delta = 60$ à 300 K, pour un empilement possédant ou non une anisotropie de surface. Deux valeurs d'anisotropie de volume y sont présentées.

Les graphes illustrés aux figures 14a à 14d représentent les graphiques de $M_S^{FM\,opti}$ and $t^{FM\,opti}$ calculés pour différentes valeurs d'anisotropie $K_s$ et $K_u$ en fonction du diamètre de la jonction tunnel.

Afin de minimiser la dispersion de facteur de stabilité thermique et de courant d'écriture d'un point mémoire à l'autre, on se placera dans des conditions telles que

$$\left|\frac{\partial \Delta}{\partial D}\right| < \text{crit}$$

Où *crit* est une constant positive de tolérance de dispersion. Cette tolérance est définie par le fait que les distributions de tension d'écriture, de tension de lecture et de tension de claquage diélectrique doivent être bien séparées comme il est connu de l'homme de l'art. Typiquement, on cherchera à avoir une dispersion de $\Delta$ inférieure à 40 (c'est-à-dire par exemple $\Delta = 80 \pm 20$ pour une dispersion de diamètre de jonctions tunnel de $\pm 2$nm) soit $\left|\frac{\partial \Delta}{\partial D}\right| < 10\text{nm}^{-1}$. Toutefois pour réaliser des mémoires de haute capacité (quelques Gbit), il sera nécessaire d'avoir une distribution de tension d'écriture plus étroite donc un critère plus stricte $\left|\frac{\partial \Delta}{\partial D}\right| < 3\text{nm}^{-1}$ voire $\left|\frac{\partial \Delta}{\partial D}\right| < 1\text{nm}^{-1}$. Ceci signifie travailler de plus en plus proche de la condition optimale définie par $L^{FM\,opti}$ et $Ms^{FM\,opti}$.

Dans le cas d'une couche de stockage constituée d'un seul matériau homogène d'aimantation uniforme, la condition $\left|\frac{\partial \Delta}{\partial D}\right| < \text{crit}$ s'écrit $\left|\frac{2\Delta}{D} - \frac{3abL^2D^2}{(D+bL)^2}\right| < \text{crit}$ où les constantes a et b ont été précédemment définies.

La figure 15 illustre les zones de paramètres (diamètre (D), épaisseur (L)) dans lesquelles on obtient une valeur $\left|\frac{\partial \Delta}{\partial D}\right|$ inférieure à un certain critère crit égal à 5, 10, ou 20nm$^{-1}$ sur la figure. La figure est représentée sous une forme multi échelle permettant de couvrir différents types de matériaux représentés par leur aimantation en code couleur. Pour établir cette figure, on calcule les variations de stabilité $\delta\Delta$ qu'implique une variation de diamètre $\delta D$ donnée (c'est-à-dire $\left|\frac{\partial \Delta}{\partial D}\right|$ ), en fonction des paramètres D, $\Delta$, L et $M_S$ et en considérant $K_S = 0$ et $K_u = 0$. On trace alors en code de hachure la valeur de $\left|\frac{\partial \Delta}{\partial D}\right|$ en fonction de $\Delta$ (axe des ordonnées) et de D (axe des abscisses), pour tout $M_S$ (code couleur) et pour différentes valeurs de L (axes colorés). Des hachures verticales indiquent que $\left|\frac{\partial \Delta}{\partial D}\right| < 5 \text{ nm}^{-1}$, des hachures horizontales indiquent que $5 < \left|\frac{\partial \Delta}{\partial D}\right| < 10 \text{ nm}^{-1}$, des hachures en croix indiquent que $10 < \left|\frac{\partial \Delta}{\partial D}\right| < 20 \text{ nm}^{-1}$

et tout ce qui est au-delà des hachures indique que $\left|\frac{\partial \Delta}{\partial D}\right| > 20$ nm$^{-1}$. Par exemple, il est raisonnable de considérer que $\Delta$ ne doit pas varier de plus de $\pm 20$ pour des variations de diamètre de $\pm 2$ nm, soit $\left|\frac{\partial \Delta}{\partial D}\right| < 10$ nm$^{-1}$. Ainsi, les zones hachurées verticales et horizontales montrent tout le domaine dans lequel on peut se placer tout en satisfaisant cette propriété. Par exemple, considérons le cas du Cobalt (courbe iso-$M_S$ = Co) avec une épaisseur L = 15 nm (axes bleus). Les conditions optimales $\left(\left|\frac{\partial \Delta}{\partial D}\right| = 0\right)$ de ce cas correspondent au maximum de l'iso-$M_S$ et correspondent environ au point de fonctionnement { D = 10.9 nm, $\Delta$ = 60}. En revanche, si le critère est $\left|\frac{\partial \Delta}{\partial D}\right| < 10$ nm$^{-1}$ par exemple au lieu d'être $\left|\frac{\partial \Delta}{\partial D}\right| = 0$ mais que l'on veut spécifiquement avoir $\Delta$ = 55, alors il est possible en se déplaçant vers la gauche sur l'iso-Ms de trouver un point de fonctionnement { D = 8.8 nm, $\Delta$ = 55} qui satisfasse toujours le critère désiré. Le critère n'est plus satisfait pour environ D < 8.1 nm, ce qui laisse la possibilité d'avoir une variabilité de procédé de $\pm$ 0.7 nm.

La Figure 16 montre une autre façon de présenter l'influence de la variabilité du facteur de stabilité thermique pour une variabilité de diamètre de cellule donnée $\delta D$ (1nm ou 2nm sur la Figure 16) en fonction du diamètre de la cellule dans différentes conditions d'anisotropie de surface et de volume. Pour chaque valeur de diamètre, et de paramètres d'anisotropie Ks et Ku fixés, on se place aux conditions optimales d'épaisseur et d'aimantation { $L^{opti}$, $M_S^{opti}$ }.

Pour se faire, les résultats présentés en figure 16, sont calculés de la manière suivante. L'axe des abscisses représente le diamètre cible D. L'axe des ordonnées représente un paramètre variable $\Delta$, $K_S$ ou $K_u$, les deux autres étant fixés. Pour chaque point des diagrammes, les paramètres optimaux { $L^{opti}$, $M_S^{opti}$ } sont calculés via la méthode présentée précédemment. En utilisant l'ensemble de ces paramètres, on trace en code couleur la variation relative de stabilité maximale $\delta\Delta$ (en % de la stabilité cible $\Delta$) lors d'une variabilité du diamètre D $\pm$ $\delta D$. En d'autres termes, pour toutes valeurs de diamètre $\in$ [D - $\delta D$; D + $\delta D$], on a une stabilité $\in$ [$\Delta$(1 - $\delta\Delta$); $\Delta$(1 + $\delta\Delta$)]. Les diagrammes sont calculés pour $\delta D$ = 1 nm (colonne gauche) et $\delta D$ = 2 nm (colonne droite). Ces diagrammes permettent de conclure que pour les plus grands diamètres (D > 15 nm), il peut être avantageux d'avoir une anisotropie de surface ou volumique puisque ces dernières diminuent la variabilité $\delta\Delta$. Elles n'ont en revanche que peu d'influence aux petits diamètres (D < 15 nm). De plus, pour les plus grands diamètres, la variabilité $\delta\Delta$ est généralement inférieure à 2%, ce qui est faible et ce qui permet que se placer relativement loin des conditions optimales présentées dans le présent brevet. En revanche, plus le diamètre est petit, plus la variabilité $\delta\Delta$ aux conditions optimales augmente. A titre d'exemple, $\delta\Delta$ atteint les 40% pour $\delta D$ = 1 nm à D = 2.7 nm, et $\delta\Delta$ atteint les 40% pour $\delta D$ = 2 nm à D = 5.3 nm. Ainsi, si $\delta D$ = 2 nm est l'incertitude sur le procédé et $\delta\Delta$ = 40% la variation de stabilité maximale autorisée, alors si le diamètre cible est de 5 nm, alors il faut nécessairement se placer très proches des conditions optimales { $L^{opti}$, $M_S^{opti}$ } puisqu'ailleurs la variabilité $\delta\Delta$ ne peut que s'aggraver.

Il est à noter que dans certaines situations et en particulier vers les nœuds technologiques les plus petits (4nm), il peut devenir impossible de trouver un matériau possédant une aimantation optimale $M_S^{FM\,opti}$, que ce soit pour des raisons purement physiques (par exemple aucun matériau n'ayant l'aimantation optimale si celle-ci est trop grande) ou parce que lesdits matériaux ne satisfont pas d'autres critères (par exemple nécessité d'avoir un faible amortissement de Gilbert). Ceci peut se produire en particulier vers les plus petits nœuds technologiques dans la mesure où d'une façon générale, l'aimantation optimale du matériau de la couche ferromagnétique de stockage augmente lorsque le diamètre de la jonction tunnel diminue. Dans ce cas, s'il devient impossible de satisfaire l'égalité $\frac{\partial \Delta}{\partial D} = 0$, on va chercher à se placer au point de plus bas $\left(\left|\frac{\partial \Delta}{\partial D}\right|\right)$ accessible. Une analyse des diagrammes tel que celui donné en figure 15 conduit au fait qu'il faut choisir le matériau possédant la plus grande aimantation $M_S$ (avec $M_S < M_S^{opti}$ ), puis adapter l'épaisseur pour obtenir la stabilité souhaitée. Dans ce cas, l'épaisseur s'obtient suivant :

$$L = \frac{1}{2(abD^2 + bcD^2K_u)}\Big[(2aD^3 + b\Delta - cD^3K_u - bcD^2K_S) + \sqrt{(2aD^3 + b\Delta - cD^3K_u - bcD^2K_S)^2 + 4(abD^2 + bcD^2K_u)(D\Delta - cD^3K_S)}\Big]$$

Il est à noter que les valeurs de $L^{FM\ opti}$ et $Ms^{FM\ opti}$ dépendent de la température. Avantageusement, pour un dispositif devant fonctionner sur une gamme de température de $T_{min}$ à $T_{max}$, par exemple 0°C à 85°C, on cherchera à se rapprocher des conditions optimales à la température moyenne $(T_{min} + T_{max})/2$.

Notons qu'il est aussi possible de donner à la couche de référence une forme verticalement allongée pour augmenter son anisotropie perpendiculaire. Toutefois un inconvénient est qu'alors le champ rayonné par cette couche sur la couche de stockage devient très important de sorte qu'il peut devenir nécessaire de compenser ce champ rayonné par l'application d'un champ magnétique de compensation.

**Revendications**

1. Jonction tunnel magnétique à aimantation hors du plan comprenant :

  ◦ une couche de stockage (SL) ayant une aimantation commutable entre deux états d'aimantation perpendiculaire au plan de la couche ;
  ◦ une couche de référence (RL) ayant une aimantation fixe et perpendiculaire au plan de la couche ;
  ◦ une couche barrière tunnel (TB) séparant la couche de stockage et la couche de référence ;
  les deux états d'aimantation de la couche de stockage étant séparés par une barrière d'énergie comprenant une contribution due à l'anisotropie de forme de la couche de stockage et une contribution d'origine interfaciale pour chaque interface de la couche de stockage, et :
  ◦ la couche de stockage (SL) présentant une épaisseur comprise entre 0.8 et 8 fois une dimension caractéristique d'une section planaire de la jonction tunnel ;
  ◦ et la contribution à la barrière d'énergie due à l'anisotropie de forme de la couche de stockage étant au moins deux fois supérieure aux contributions à la barrière d'énergie d'origine interfaciale ; ladite jonction tunnel étant **caractérisée en ce que** la couche de stockage (SL) comporte une couche interfaciale (I) faite d'un alliage riche en cobalt au contact de la barrière tunnel (TB).

2. Jonction tunnel selon la revendication précédente **caractérisée en ce que** la couche de stockage comporte une couche volumique présentant une température de Curie supérieure à 400°C et de préférence supérieure à 600°C et de préférence supérieure à 800°C.

3. Jonction tunnel selon l'une des revendications précédentes **caractérisée en ce qu'**elle comporte une seule couche barrière tunnel (TB).

4. Jonction tunnel selon l'une des revendications précédentes **caractérisée en ce que** la contribution à la barrière d'énergie due à l'anisotropie de forme de la couche de stockage (SL) est au moins quatre fois supérieure aux contributions à la barrière d'énergie d'origine interfaciale.

5. Jonction tunnel selon l'une des revendications précédentes **caractérisée en ce que** la couche de stockage (SL) comprend un ou plusieurs matériaux magnétiques présentant une température de Curie supérieure à 400°C et de préférence supérieure à 600°C et de préférence supérieure à 800°C.

6. Jonction tunnel selon l'une des revendications précédentes **caractérisée en ce que** la couche de stockage (SL) comprend un alliage comprenant du cobalt et/ou du fer et un élément amorphisant tel que le bore, ledit alliage étant en contact avec la couche barrière tunnel.

7. Jonction tunnel selon la revendication 6 **caractérisées en ce que** la couche de stockage (SL) contient une ou plusieurs couches de matériaux tels que du Ta, W, Mo, Hf, aptes à absorber l'élément amorphisant présent dans la couche de stockage et à assurer des transitions structurales entre les différents matériaux magnétiques compris dans la couche de stockage.

8. Jonction tunnel magnétique selon une des revendications précédentes **caractérisée en ce que** sa section est circulaire ou quasi circulaire et que la dimension caractéristique est le diamètre de la section.

9. Jonction tunnel magnétique selon la revendication 8 **caractérisée en ce que** le diamètre est inférieur à 50nm.

10. Jonction tunnel selon l'une des revendications précédentes **caractérisée en ce que** :

- la couche barrière tunnel (TB) est réalisée en MgO, AlOx, AlN, $SrTiO_3$, HfOx ou tout autre oxyde ou nitride isolant ;
- la couche de stockage (SL) comprend :

  ∘ une couche en alliage de cobalt, fer et élément amorphisant d'épaisseur entre 1 et 4nm en contact avec la barrière tunnel ;
  ∘ une couche d'un matériau apte à absorber le bore, tel que Ta, Mo, W, Hf au moment des recuits post-dépôt, d'épaisseur 0.2 à 0.4nm ;
  ∘ une couche magnétique à faible amortissement de Gilbert.

11. Jonction tunnel magnétique selon l'une des revendications précédentes **caractérisée en ce que** :

  ∘ ladite jonction tunnel magnétique possède un facteur de stabilité dépendant de la barrière d'énergie et de la température d'utilisation de la jonction tunnel magnétique ;
  ∘ la composition et l'épaisseur de la couche de stockage (SL) sont choisies de sorte que la valeur absolue de la dérivée du facteur de stabilité thermique par rapport à une dimension caractéristique d'une section planaire de la jonction tunnel soit inférieure à 10 $nm^{-1}$, la dérivée du facteur de stabilité étant calculée à une température $T_m$, la température $T_m$ étant la température moyenne d'utilisation de la jonction tunnel magnétique.

12. Point mémoire magnétique à accès aléatoire de type « spin-transfer torque » ou STT-MRAM comprenant une jonction tunnel magnétique selon l'une des revendications 1 à 11.

13. Point mémoire magnétique à accès aléatoire de type « spin-orbit transfer » ou SOT-MRAM comprenant une jonction tunnel magnétique selon l'une des revendications 1 à 11.

14. Point mémoire magnétique à accès aléatoire à écriture contrôlée en tension comprenant une jonction tunnel magnétique selon l'une des revendications 1 à 11.

15. Elément non volatile d'un composant logique comprenant une jonction tunnel magnétique selon l'une des revendications 1 à 11.

16. Procédé de fabrication (P) d'une jonction tunnel magnétique selon l'une quelconque des revendications 1 à 11 comprenant les étapes suivantes :

  • Dépôt (D) de l'ensemble des couches par dépôt physique en phase vapeur ;
  • Gravure (RIE) de la couche de stockage (SL) ou couche magnétique épaisse par gravure ionique réactive ;
  • Gravure (IBE) des autres couches par gravure ionique.


**Patentansprüche**

1. Magnetischer Verbindungstunnel mit Magnetisierung außerhalb der Ebene, umfassend:

o eine Speicherschicht (SL) mit einer Magnetisierung, die zwischen zwei Magnetisierungszuständen schaltbar und zur Ebene der Schicht lotrecht ist;
o eine Referenzschicht (RL), die eine feste und zur Ebene der Schicht lotrechte Magnetisierung aufweist;
o eine Tunnelschrankenschicht (TB), die die Speicherschicht und die Referenzschicht voneinander trennt;
wobei die zwei Magnetisierungszustände der Speicherschicht durch eine Energieschranke getrennt sind, die einen Beitrag umfasst, der auf die Form-Antisotropie der Speicherschicht zurückzuführen ist, und einen Beitrag eines Schnittstellenursprungs für jede Schnittstelle der Speicherschicht und
o die Speicherschicht (SL), die eine Dicke aufweist, die zwischen dem 0,8- und dem 8-Fachen einer charakteristischen Abmessung eines planaren Abschnitts der Tunnelverbindung inbegriffen ist;

o und den Beitrag zur Energieschranke aufgrund der Form-Anisotropie der Speicherschicht, der wenigstens um das Zweifache höher ist als die Beiträge zur Energieschranke des Schnittstellenursprungs;

wobei die genannte Verbindungstunnel **dadurch gekennzeichnet ist, dass** die Speicherschicht (SL) eine Schnittstellenschicht (I) umfasst, die aus einer an Kobalt reichen Legierung in Kontakt mit der Tunnelschranke (TB) hergestellt ist.

2. Verbindungstunnel gemäß dem voranstehenden Anspruch, **dadurch gekennzeichnet, dass** die Speicherschicht eine Volumenschicht umfasst, die eine Curie-Temperatur von mehr als 400° C und bevorzugt mehr als 600° C und weiter bevorzugt von 800° C aufweist.

3. Verbindungstunnel gemäß einem der voranstehenden Ansprüche, **dadurch gekennzeichnet, dass** sie eine einzige Tunnelschranken-Schicht (TB) umfasst.

4. Tunnelverbindung gemäß einem der voranstehenden Ansprüche, **dadurch gekennzeichnet, dass** der Beitrag zur Energieschranke aufgrund der Form-Anisotropie der Speicherschicht (SL) wenigstens vier Mal größer ist als die Beiträge zur Energieschranke eines Schnittstellenursprungs.

5. Tunnelverbindung gemäß einem der voranstehenden Ansprüche, **dadurch gekennzeichnet, dass** die Speicherschicht (SL) ein oder mehrere magnetische(s) Material(ein) umfasst, das / die eine Curie-Temperatur von mehr als 400° C und bevorzugt mehr als 600° C und weiter bevorzugt mehr als 800° C aufweist / aufweisen.

6. Tunnelverbindung gemäß einem der voranstehenden Ansprüche, **dadurch gekennzeichnet, dass** die Speicherschicht (SL) eine Legierung umfasst, umfassend Kobalt und / oder Eisen und ein amorphisierendes Element, wie z. B. Bor, wobei die genannte Legierung mit der Tunnelschranken-Schicht in Kontakt ist.

7. Tunnelverbindung gemäß Anspruch 6, **dadurch gekennzeichnet, dass** die Speicherschicht (SL) eine oder mehrere Materialschicht(en), wie z. B. Ta, W, Mo, Hf enthält, die geeignet sind, das amorphisierende Element zu absorbieren, das in der Speicherschicht vorhanden ist und strukturelle Übergänge zwischen den unterschiedlichen magnetischen Materialien zu gewährleisten, die in der Speicherschicht inbegriffen sind.

8. Magnetische Tunnelverbindung gemäß einem der voranstehenden Ansprüche, **dadurch gekennzeichnet, dass** ihr Querschnitt kreisförmig oder quasi-kreisförmig ist und dass die charakteristische Abmessung der Durchmesser des Querschnitts ist.

9. Magnetische Tunnelverbindung gemäß Anspruch 8, **dadurch gekennzeichnet, dass** der Durchmesser kleiner ist als 50 nm.

10. Tunnelverbindung gemäß einem der voranstehenden Ansprüche, **dadurch gekennzeichnet, dass**:

    - die Tunnelschranken-Schicht (TB) aus MgO, AlOx, AIn, $SrTiO_3$, HfOx oder jedem anderen isolierenden Oxid oder Nitrid realisiert ist;
    - die Speicherschicht (SL) umfasst:

        o eine Legierungsschicht aus Kobalt, Eisen und einem amorphisierenden Element mit einer Dicke zwischen 1 und 4 nm in Kontakt mit der Tunnelschranke;
        o eine Schicht aus einem Material, wie z. B. Ta, Mo, W, Hf, das geeignet ist, das Bor zum Zeitpunkt des Glühens nach dem Aufbringen zu absorbieren, mit einer Dicke von 0,2 bis 0,4 nm;
        o eine magnetische Schicht mit schwacher Gilbert-Dämpfung.

11. Magnetische Tunnelverbindung gemäß einem der voranstehenden Ansprüche, **dadurch gekennzeichnet, dass**:

    o die genannte magnetische Tunnelverbindung einen Stabilitätsfaktor besitzt, der von der Energieschranke und der Nutzungstemperatur der magnetischen Tunnelverbindung abhängt;
    o die Zusammensetzung und die Dicke der Speicherschicht (SL) derart ausgewählt sind, dass der absolute Wert der Ableitung des thermischen Stabilitätsfaktors im Verhältnis zu einer charakteristischen Abmessung eines planaren Abschnitts der Tunnelverbindung kleiner als 10 nm$^{-1}$ ist, wobei die Ableitung des Stabilitätsfaktors bei einer Temperatur $T_m$ berechnet ist, wobei die Temperatur $T_m$ die durchschnittliche Nutzungstemperatur der magnetischen Tunnelverbindung ist.

12. Magnetischer Speicherpunkt mit zufälligem Zugang vom Typ "Spin Transfer Torque" oder STT-MRAM, umfassend eine magnetische Tunnelverbindung gemäß einem der Ansprüche 1 bis 11.

13. Magnetischer Speicherpunkt mit zufälligem Zugang vom Typ "Spin Orbit Transfer" oder SOT-MRAM, umfassend eine magnetische Tunnelverbindung gemäß einem der Ansprüche 1 bis 11.

14. Magnetischer Speicherpunkt mit zufälligem Zugang mit kontrolliertem Schreiben unter Spannung, umfassend eine magnetische Tunnelverbindung gemäß einem der Ansprüche 1 bis 11.

15. Nicht flüchtiges Element eines logischen Bauteils, umfassend eine magnetische Tunnelverbindung gemäß einem der Ansprüche 1 bis 11.

16. Herstellungsverfahren (P) einer magnetischen Tunnelverbindung gemäß irgendeinem der Ansprüche 1 bis 11, umfassend die folgenden Schritte:

• Aufbringen (D) aller Schichten durch physisches Aufbringen in der Dam pfphase
• Ätzen (RIE) der Speicherschicht (SL) oder dicken magnetischen Schicht durch reaktives ionisches Ätzen;
• Ätzen (IBE) der anderen Schichten durch ionisches Ätzen.


**Claims**

1. Magnetic tunnel junction with out-of-plane magnetisation comprising:

    o a storage layer (SL) having a magnetisation switchable between two magnetisation states perpendicular to the plane of the layer;
    o a reference layer (RL) having a fixed magnetisation and perpendicular to the plane of the layer;
    o a tunnel barrier layer (TB) separating the storage layer and the reference layer;
    the two magnetisation states of the storage layer being separated by an energy barrier comprising a contribution due to the shape anisotropy of the storage layer and a contribution of interfacial origin for each interface of the storage layer, and
    o the storage layer (SL) having a thickness comprised between 0.8 and 8 times a characteristic dimension of a planar section of the tunnel junction;
    o and the contribution to the energy barrier due to the shape anisotropy of the storage layer being at least two times greater than the contributions to the energy barrier of interfacial origin;
    said tunnel being **characterized in that** the storage layer (SL) comprises an interfacial layer (I) made of an alloy rich in cobalt in contact with the tunnel barrier (TB).

2. Tunnel junction according to the preceding claim **characterised in that** the storage layer comprises a volume layer having a Curie temperature above 400°C and preferably above 600°C and preferably above 800°C.

3. Tunnel junction according to one of the preceding claims **characterised in that** it comprises a single tunnel barrier layer (TB).

4. Tunnel junction according to one of the preceding claims **characterised in that** the contribution to the energy barrier due to the shape anisotropy of the storage layer (SL) is at least four times greater than the contributions to the energy barrier of interfacial origin.

5. Tunnel junction according to one of the preceding claims **characterised in that** the storage layer (SL) comprises one or more magnetic materials having a Curie temperature above 400°C and preferably above 600°C and preferably above 800°C.

6. Tunnel junction according to one of the preceding claims **characterised in that** the storage layer (SL) comprises an alloy comprising cobalt and/or iron and an amorphising element such as boron, said alloy being in contact with the tunnel barrier layer.

**7.** Tunnel junction according to claim 6 **characterised in that** the storage layer (SL) contains one or more layers of materials such as Ta, W, Mo, Hf, able to absorb the amorphising element present in the storage layer and to ensure structural transitions between the different magnetic materials comprised in the storage layer.

**8.** Magnetic tunnel junction according to one of the preceding claims **characterised in that** its section is circular or quasi-circular and that the characteristic dimension is the diameter of the section.

**9.** Magnetic tunnel junction according to claim 8 **characterised in that** the diameter is less than 50 nm.

**10.** Tunnel junction according to one of the preceding claims **characterised in that**:

- the tunnel barrier layer (TB) is made of MgO, AlOx, AIN, SrTiO$_3$, HfOx or any other insulating nitride or oxide;
- the storage layer (SL) comprises:

   o a layer made of alloy of cobalt, iron and amorphising element of thickness between 1 and 4 nm in contact with the tunnel barrier;
   o a layer of a material able to absorb boron, such as Ta, Mo, W, Hf at the moment of post-deposition annealings, of 0.2 to 0.4 nm thickness;
   o a magnetic layer with low Gilbert dampening.

**11.** Magnetic tunnel junction according to one of the preceding claims **characterised in that**:

   o said magnetic tunnel junction has a stability factor dependent on the energy barrier and the temperature of use of the magnetic tunnel junction;
   o the composition and the thickness of the storage layer (SL) are chosen such that the absolute value of the derivative of the thermal stability factor compared to a characteristic dimension of a planar section of the tunnel junction is less than 10 nm$^{-1}$, the derivative of the stability factor being calculated at a temperature $T_m$, the temperature $T_m$ being the average temperature of use of the magnetic tunnel junction.

**12.** Magnetic random access memory point of "spin-transfer torque" or STT-MRAM type comprising a magnetic tunnel junction according to one of claims 1 to 11.

**13.** Magnetic random access memory point of "spin-orbit transfer" or SOT-MRAM type comprising a magnetic tunnel junction according to one of claims 1 to 11.

**14.** Magnetic random access memory point with voltage controlled writing comprising a magnetic tunnel junction according to one of claims 1 to 11.

**15.** Non-volatile element of a logic component comprising a magnetic tunnel junction according to one of claims 1 to 11.

**16.** Method for manufacturing (P) a magnetic tunnel junction according to any of claims 1 to 11 comprising the following steps:

   • Deposition (D) of all of the layers by physical vapour deposition;
   • Etching (RIE) of the storage layer (SL) or thick magnetic layer by reactive ion etching;
   • Etching (IBE) of the other layers by ion beam etching.

Figure 1

Figure 2

Figure 3

EP 3 531 432 B1

Figure 4

Figure 5

Figure 6

EP 3 531 432 B1

PSA-MRAM-1

Figure 7

Figure 8

EP 3 531 432 B1

Figure 9

Figure 10a

Figure 10b

Figure 11

Figure 12

Figure 13

Figure 14

Figure 15

Figure 16

45

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8247093 B2
- US 8513944 B2
- US 20150036415 A1

**Littérature non-brevet citée dans la description**

- **TAKAYUKI KAWAHARA.** Challenges toward giga-bit-scale spin-transfer torque random access memory and beyond for normally off, green information technology infrastructure. *J. Appl. Phys.,* 2011, vol. 109, 07D325
- **SLONCZEWSKI, J. C.** Current driven excitations of magnetic multilayers. *J. Magn. Magn. Mater.,* 1996, vol. 159, L1-L7
- **BERGER, L.** Emission of spin waves by a magnetic multilayer traversed by a current. *Phys. Rev. B,* 1996, vol. 54, 4828-4830
- **KATINE, J.A. ; F. J. ALBERT ; R. A. BUHRMAN ; E. B. MYERS ; D. C. RALPH.** Current-driven magnetization reversai and spin-wave excitations in Co /Cu /Co pillars. *Phys. Rev. Lett.,* 2000, vol. 84, 3149-3152
- Magnetic Random Access Memory. **B.DIENY ; L.PREJBEANU.** Introduction to Magnetic Random Access Memory. IEEE Press
- **APALKOV, D. ; B. DIENY ; J. M. SLAUGHTER.** Magnetoresistive Random Access Memory. *Proceedings of the IEEE,* 2016, vol. 104, 1796-1830
- **IKEDA, S. ; K. MIURA ; H. YAMAMOTO ; K. MIZUNUMA ; H. D. GAN ; M. ENDO ; S. KANAI ; J. HAYAKAWA ; F. MATSUKURA ; H. OHNO.** A perpendicular-anisotropy CoFeB-MgO magnetic tunnel junction. *Nature Mater.,* 2010, vol. 9, 721-724
- **YANG, H. X. ; M. CHSHIEV ; B. DIENY ; J. H. LEE ; A. MANCHON ; K. H. SHIN.** First principles investigation of the very large perpendicular magnetic anisotropy at Fe|MgO and Co|MgO interfaces. *Phys. Rev. B,* 2011, vol. 84, 054401
- **SATO, H. ; T. YAMAMOTO ; M. YAMANOUCHI ; S. IKEDA ; S. FUKAMI ; K. KINOSHITA ; F. MATSUKURA ; N. KASAI ; H. OHNO.** Comprehensive study of CoFeB-MgO magnetic tunnel junction characteristics with single- and double-interface scaling down to 1X nm. *Proceedings of the International Electron Devices Meeting (IEDM),* 2014, 33.2.1-33.2.4

- **M. SATO ; Y. ISHII.** *J. Appl. Phys.,* 1989, vol. 60, 983
- **DU-XING CHEN ; JAMES A. BRUG.** Member. IEEE
- **RONALD B. GOLDFARB.** Demagnetizing Factors for Cylinders. *IEEE Trans.Mag.,* 1991, vol. 4, 3601
- **M BELEGGIA ; M DE GRAEF ; Y T MILLEV ; D A GOODE ; G ROWLANDS.** Demagnetization factors for elliptic cylinders. *J. Phys. D: Appl. Phys.,* 2005, vol. 38, 3333
- **SUN, J. Z.** Spin-current interaction with a monodomain magnetic body: A model study. *Phys. Rev. B,* 2000, vol. 62, 570-578
- **K. WATANABE et al.** *Nature Communications,* 14 Février 2018, vol. 9 (1
- **KYOUNG-MIN LEE ; JUN WOO CHOI ; JUNGHYUN SOK ; BYOUNG-CHUL MIN.** Temperature dependence of the interfacial magnetic anisotropy in W/CoFeB/MgO. *AIP Advances,* 2017, vol. 7, 065107
- **KYOUNG-MIN LEE et al.** Temperature dependence of the interfacial magnetic anisotropy in W/CoFeB/MgO. *AIP Advances,* 2017, vol. 7, 065107
- **MARTIN A.W ; SCHOEN DANNY THONIG ; MICHAEL L. SCHNEIDER ; T. J. SILVA ; HANS T. NEMBACH ; OLLE ERIKSSON ; OLOF KARIS ; JUSTIN M. SHAW.** Ultra-low magnetic damping of a metallic ferromagnet. *Nat.Phys.,* 2016, vol. 12, 839
- **S.FUKAMI ; C.ZHANG ; S.DUTTA GUPTA ; A.KURENKOV ; H.OHNO.** Magnetization switching by spin-orbit torque in an antiferromagnet-ferromagnet bilayer system. *Nat.Mat.,* 2017, vol. 15, 535
- **Y.SHIOTA ; T.NOZAKI ; F.BONELL ; S.MURAKAMI ; T.SHINJO ; Y. SUZUKI.** Induction of coherent magnetization switching in a few atomic layers of FeCo using voltage puises. *Nature Materials,* 2012, vol. 11, 39